# EUROPEAN PATENT SPECIFICATION

(11) **EP 2 568 019 B1**
(45) Date of publication and mention of the grant of the patent: **02.09.2015**
(21) Application number: 12183396.6
(22) Date of filing: 06.09.2012
(51) Int. Cl.: C09D 11/00, H05K 3/46, C08G 73/10, C08L 79/08, C09D 11/36, C09D 11/38

(54) **Inkjet ink**
Tintenstrahltinte
Encre pour jet d'encre

(30) Priority: 07.09.2011 JP 2011194888
(43) Date of publication of application: 13.03.2013
(73) Proprietor: JNC Corporation, Chiyoda-ku Tokyo 100-8105 (JP)
(72) Inventor: Furuta, Tomotsugu, Ichihara-shi, Chiba 2908551 (JP); Anraku, Hiroshi, Ichihara-shi, Chiba 2908551 (JP); Kikuchi, Ayako, Ichihara-shi, Chiba 2908551 (JP); Tanioka, Satoshi, Ichihara-shi, Chiba 2908551 (JP); Kikukawa, Takashi, Ichihara-shi, Chiba 2908551 (JP)
(74) Representative: Wills, Andrew Jonathan

(56) References cited:
- EP-A1- 1 872 940
- EP-A1- 1 894 977
- EP-A2- 1 550 698
- US-A1- 2009 202 786

## Description

### Technical Field

The present invention relates to an inkjet ink containing an amide acid derivative having a specific structure or an imidized substance thereof, and a solvent having a specific structure. More particularly, the invention relates to, for example, an inkjet ink used for forming an insulating film layer in manufacturing the electronic component, a polyimide film formed by using the inkjet ink, a substrate for an electronic material having the polyimide film, and an electronic component having the substrate for the electronic material.

### Background Art

A patterned cured film is used in electronics and communication field. Such a patterned cured film has been prepared so far by forming a cured film by using a photosensitive material or the like and then carrying out etching or the like. However, formation of the patterned cured film according to the method needs a large amount of various kinds of materials and chemical solutions, such as a photoresist, a developer, an etchant and a stripper, and a complicated process. Therefore, the method has been inferior in productivity.

Therefore, a research has been conducted for a method for directly forming a desired patterned cured film according to an inkjet method in recent years. An inkjet ink is used for the inkjet method. Various kinds of inkjet inks have been proposed (Patent literatures 1 and 2). In the inkjet ink, various parameters such as viscosity or surface tension of an ink and a boiling point of a solvent should be optimized in view of jettability, printability and so forth.

The viscosity is generally required to be low in the range of about 1 to 50 mPa·s at a jetting temperature (temperature of the ink during jetting the ink). In particular, jetting pressure is low in a case of inkjet printing according to a piezoelectric system. Therefore, ink jetting may become quite difficult when the viscosity is increased.

The surface tension is adjusted preferably in the range of 20 to 70 mN/m, further preferably, in the range of 20 to 40 mN/m. If the surface tension is too low, the ink spreads immediately after the ink is jetted from an output port, and formation of good liquid droplets may be quite difficult. On the contrary, if the surface tension is too high, formation of a meniscus becomes quite difficult. Therefore, jetting may become quite difficult.

The boiling point of the solvent is preferably in the range of 100 to 300°C, further preferably, in the range of 150 to 270°C. If the boiling point is too low, the solvent in the ink is evaporated, particularly when the ink is warmed and jetted. Thus, the viscosity of the ink is changed, and jetting of the ink may become quite difficult or a component of the ink may be solidified. On the contrary, if the boiling point is too high, drying of the ink after printing is too slow, and a cured film having a desired pattern is not obtained in some cases.

In the electronics and communication field, a polyimide film is widely used as the cured film because the polyimide film has an excellent heat resistance and electric insulation (Patent literatures 3 to 5).

Various kinds of inkjet inks for forming the polyimide film have been proposed such as an ink containing polyimide or an ink containing a polyamide acid that is converted into the polyimide by carrying out heat treatment (Patent literatures 6 to 11).

In the inkjet ink for forming the polyimide film, the resultant polyimide film should have predetermined functions and characteristics as an important matter, in addition to requisite characteristics such as the viscosity and the surface tension as the inkjet ink and the boiling point of the solvent as described above. Various characteristics are required to be within a specific range, for example, electrical characteristics such as volume resistivity, withstand voltage, a dielectric constant and a dielectric loss, mechanical characteristics such as properties by a bending test, an elastic modulus and tensile elongation, chemical stability such as acid resistance, alkali resistance and plating resistance, and thermal characteristics such as a thermal decomposition temperature, a glass transition temperature and a coefficient of linear thermal expansion. Furthermore, secondary characteristics are also required, such as adhesiveness with a substrate, resistance to warpage caused by shrinkage during film formation, and migration resistance. Moreover, patternability or storage stability is also required for the inkjet ink.

The polyimide has been widely used for an electronic material application as a resin for forming a film having excellent electrical, mechanical, chemical and thermal characteristics. However, there are various restrictions on preparing the inkjet ink for forming the polyimide film, and preparation of the inkjet ink having required characteristics with a sufficient balance has not been easy. In particular, preparation of the inkjet ink having an excellent patternability or storage stability has not been easy.

In order to prepare the inkjet ink having the excellent patternability or storage stability, selection of the solvent to be used is thought to be important. However, the solvent to be used is limited in the inkjet ink for forming the polyimide film in view of solubility of the polyimide or polyamide acid to be dissolved. For example, 1-methyl-2-pyrrolidone, N,N-dimethylacetamide, N,N-diethylacetamide or N,N-dimethylpropionamide as a good solvent for the polyamide acid or polyimide has been used.

In the inkjet ink for forming the polyimide film as prepared by using the solvents described above, controlling has not been easy for the viscosity, the surface tension, the patternability and the storage stability of the ink, and for the required characteristics of the resultant polyimide film.

In recent years, β-alkoxypropionamides have been reported as a solvent having affinity with both water and an organic solvent (Patent literatures 12 to 14).

However, no example has been reported so far in which the inkjet of polyamide acid or polyimide is prepared by using β-alkoxypropionamide.

### Citation List

### Patent Literature

Patent literature 1: JP 2003-213165 A.
Patent literature 2: JP 2006-131730 A.
Patent literature 3: JP 2000-039714 A.
Patent literature 4: JP 2003-238683 A.
Patent literature 5: JP 2004-094118 A.
Patent literature 6: JP 2009-35700 A.
Patent literature 7: WO 2008/123190 A.
Patent literature 8: JP 2009-144138 A.
Patent literature 9: WO 2008/059986 A.
Patent literature 10: JP 2009-203440 A.
Patent literature 11: JP 2009-221309 A.
Patent literature 12: JP 2011-68838 A.
Patent literature 13: JP 2005-47885 A.
Patent literature 14: JP 2010-280847 A.

### Summary of Invention

### Technical Problem

An objective of the invention is to provide an inkjet ink having a good jettability and storage stability, and allowing drawing of a desired pattern.

Another objective of the invention is to provide an inkjet ink for forming a polyimide film, in which parameters such as viscosity and surface tension of an ink, and a boiling point of a solvent can be easily optimized so as to compose an ink having an excellent jettability, printability and so forth.

### Solution to Problem

The inventors of the invention have diligently conducted research in order to solve the problem, as a result, have found that the problem can be solved by preparing an inkjet ink with a composition including an amide acid derivative having a specified structure or an imidized substance thereof, and a specific amide-based solvent, and have completed the invention based on the finding. More specifically, the invention includes items as described below.
Item 1. An inkjet ink, containing
   a component (A) including at least one kind of compound selected from compound (2) having a constitutional unit represented by formula (2a) described below and having at least one kind of molecular terminal group selected from the group of groups represented by formulas (2b) and (2c) described below, and compounds selected from the group of compounds represented by formula (3) to formula (6) described below, or an imidized substance thereof, and
   an amide-based solvent (B) represented by formula (1) described below. 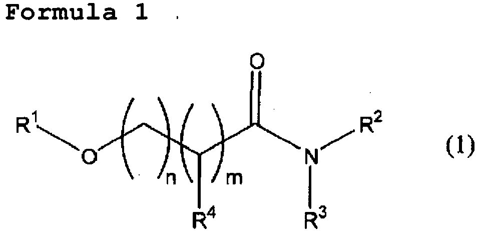 wherein, in the formula (1), R¹ is an organic group having 1 to 18 carbon atoms, R² and R³ satisfy requirement (i) or (ii) described below, R⁴ is hydrogen or methyl, n is an integer from 0 to 3, and m is 0 or 1.
   (i) : R² and R³ are each independently hydrogen or an organic group having 1 to 6 carbon atoms; or
   (ii)_{:} R² and R³ are bonded with each other to form a ring structure. 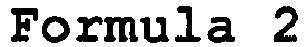 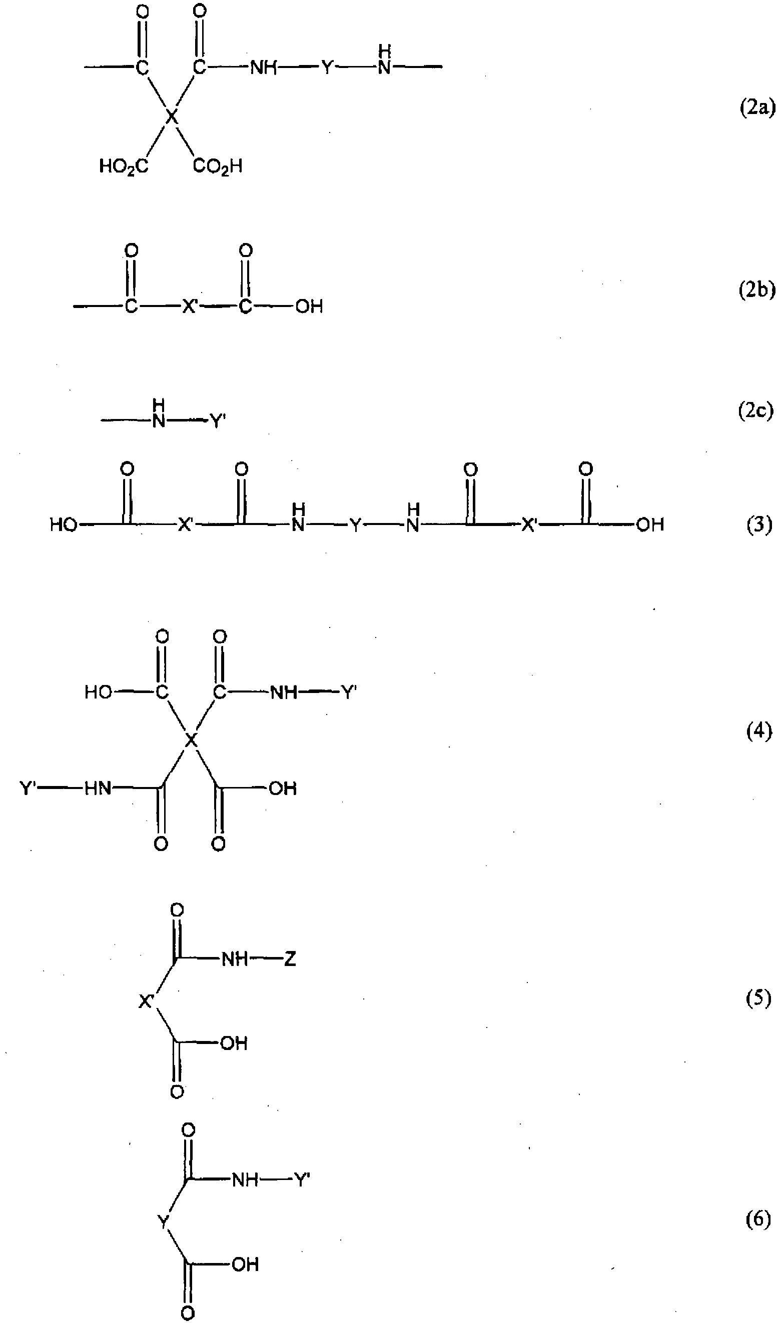
   wherein, in the formulas (2a) and (4), X is each independently carbon or an organic group having 2 to 100 carbon atoms, in the formulas (2a), (3) and (6), Y is each independently an organic group having 1 to 100 carbon atoms, in the formula (5), Z is an organic group having 1 to 100 carbon atoms, in the formulas (2b), (3) and (5), X' is each independently an organic group having 1 to 100 carbon atoms, and in the formulas (2c), (4) and (6), Y' is each independently an organic group having 1 to 100 carbon atoms.
Item 2. The inkjet ink according to item 1, wherein R¹ in the formula (1) is alkyl having 1 to 8 carbon atoms.
Item 3. The inkjet ink according to item 1 or 2, wherein the compound (2) is at least one kind of compound selected from the group of compounds represented by formula (2-1) to formula (2-3) described below. 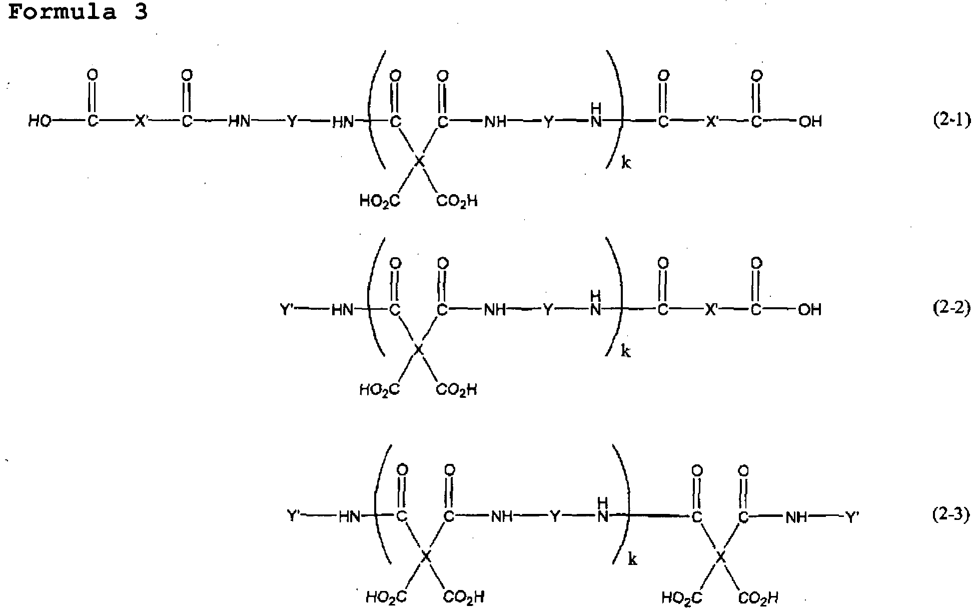 wherein, in the formula (2-1) to formula (2-3), X is each independently defined in a manner identical with X in the formulas (2a) and (4), in the formula (2-1) to formula (2-3), Y is each independently defined in a manner identical with Y in the formulas (2a), (3) and (6), in the formulas (2-1) and (2-2), X' is each independently defined in a manner identical with X' in the formulas (2b), (3) and (5), in the formulas (2-2) and (2-3), Y' is each independently defined in a manner identical with Y' in the formulas (2c), (4) and (6), and in the formula (2-1) to formula (2-3), k is each independently an integer from 1 to 8.
Item 4. The inkjet ink according to any one of items 1 to 3, wherein X' in the formulas (2b), (3), (5), (2-1) and (2-2) is each independently an organic group having an unsaturated hydrocarbon group and having 2 to 100 carbon atoms, or an organic group represented by formula (α) described below, and Y' in the formulas (2c), (4), (6), (2-2) and (2-3) is each independently an organic group having an unsaturated hydrocarbon group and having 2 to 100 carbon atoms, or an organic group represented by formula (β) described below. 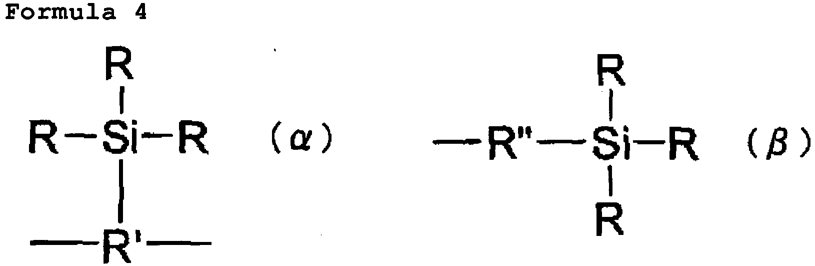 wherein, in the formulas (α) and (β), R is each independently hydrogen, alkyl having 1 to 20 carbon atoms or alkoxy having 1 to 20 carbon atoms, in the formula (α), R' is an organic group having 1 to 20 carbon atoms, and in the formula (β), R" is an organic group having 1 to 20 carbon atoms.
Item 5. The inkjet ink according to any one of items 1 to 4, further containing solvent (B') other than amide-based solvent (B).
Item 6. The inkjet ink according to any one of items 1 to 5, wherein the component (A) is contained in an amount in the range of 5 to 95% by weight based on 100% by weight of the inkjet ink.
Item 7. The inkjet ink according to item 5 or 6, wherein the amide-based solvent (B) is contained in an amount in the range of 1 to 100% by weight based on 100% of the total of the amide-based solvent (B) and the solvent (B').
Item 8. A polyimide film formed using the inkjet ink according to any one of items 1 to 7.
Item 9. A method for forming a polyimide film, including a step for forming a coating film by coating the inkjet ink according to any one of items 1 to 7 on a support according to an inkjet method, and a step for forming the polyimide film by curing the coating film.
Item 10. A polyimide film prepared according to the method for forming the polyimide film according to item 9.
Item 11. The polyimide film according to item 8 or 10, wherein the polyimide film is patterned.
Item 12. A substrate for an electronic material, having the polyimide film according to item 8, 10 or 11.
Item 13. An electronic component, having the substrate for an electronic material according to item 12.

### Advantageous Effects of Invention

According to the invention, an inkjet ink having a good jettability and storage stability and allowing drawing of a desired pattern can be obtained. According to the invention, parameters such as viscosity or surface tension of the inkjet ink, and a boiling point of a solvent can also be easily optimized so as to compose an ink having an excellent jettability, printability and so forth.

If the inkjet ink of the invention is used, a patterned polyimide film can also be formed by drawing the desired pattern only in a required part according to an inkjet method. Thus, a wide variety of polyimide films in a large amount can be easily produced without needing use of a photoresist, an etchant or the like that has been used so far upon forming a patterned polyimide film, and by allowing reduction of the number of steps needed for manufacture.

### Description of Embodiments

### 1. Inkjet ink

An inkjet ink of the invention (hereinafter, referred to also as "ink of the invention") is not particularly limited, if the inkjet ink contains component (A) including an amide acid derivative described below or an imidized substance thereof, and amide-based solvent (B).

In the ink of the invention, parameters such as viscosity or surface tension, and a boiling point of a solvent are preferably optimized in view of jettability, printability and so forth.

In addition, the ink of the invention may further contain, if necessary, solvent (B'), and may also contain, if necessary, other additives in the range in which advantageous effects of the invention are not adversely affected. In addition, the ink of the invention may be either colorless or colored.

### 1.1. Component (A)

Component (A) includes amide acid derivative (A1) or imidized substance (A2) thereof. Component (A) may consist essentially of only amide acid derivative (A1), may consist essentially of only imidized substance (A2), or may consist essentially of amide acid derivative (A1) and imidized substance (A2). Amide acid derivative (A1) included in component (A) may be used alone or in combination of two or more kinds. Moreover, imidized substances (A2) included in component (A) may be used alone or in combination of two or more kinds.

### 1.1-1. Amide acid derivative (A1)

The amide acid derivative (A1) is at least one kind of compound selected from compound (2) having a constitutional unit represented by formula (2a) described below and having at least one kind of molecular terminal group selected from the group of groups represented by formulas (2b) and (2c) described below, and compounds selected from the group of compounds represented by formula (3) to formula (6) described below.

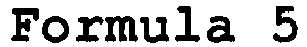

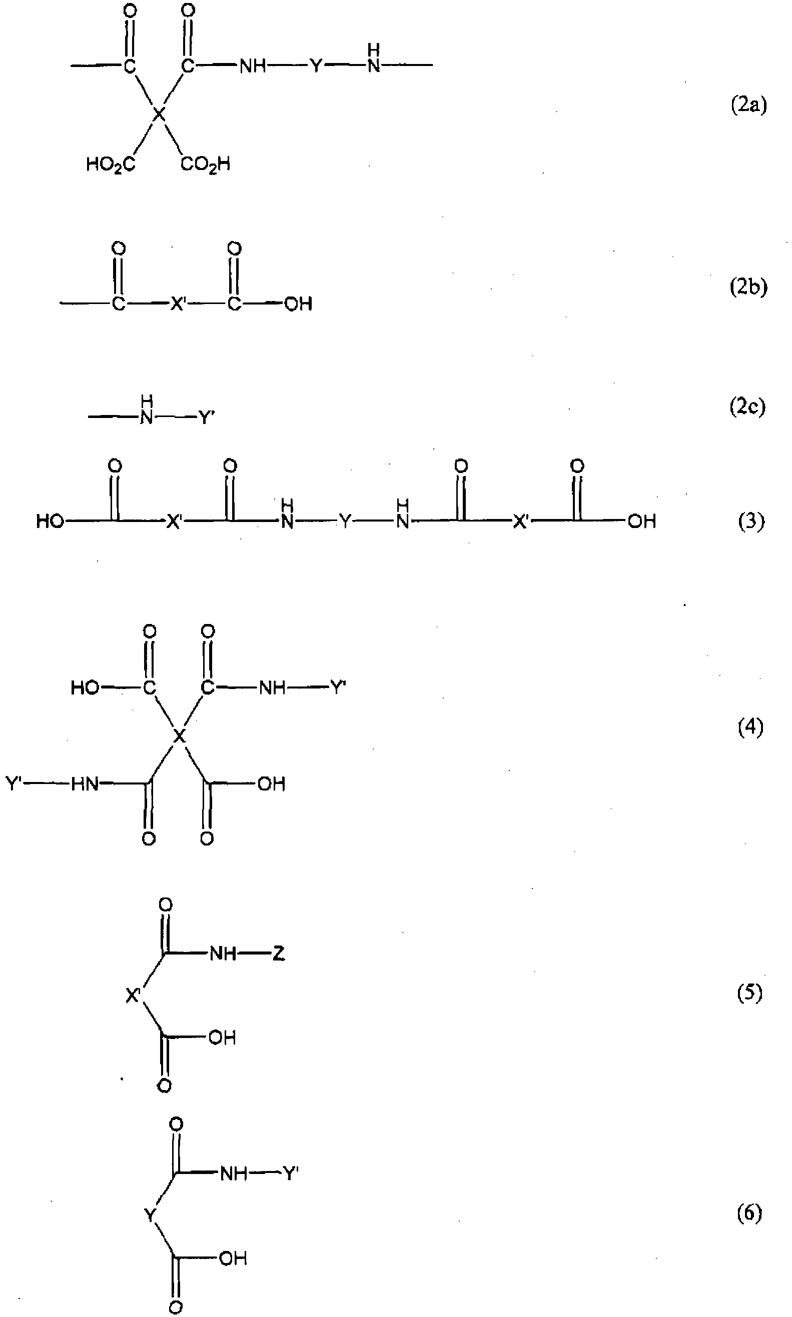

In the formulas (2a) and (4), X is each independently carbon or an organic group having 2 to 100 carbon atoms, in the formulas (2a), (3) and (6), Y is each independently an organic group having 1 to 100 carbon atoms, in the formula (5),Z is an organic group having 1 to 100 carbon atoms, in the formulas (2b), (3) and (5), X' is each independently an organic group having 1 to 100 carbon atoms, and in the formulas (2c), (4) and (6), Y' is each independently an organic group having 1 to 100 carbon atoms.

In the formulas (2a) and (4), X is each independently carbon or an organic group having 2 to 100 carbon atoms. Specific examples of the organic group having 2 to 100 carbon atoms include a hydrocarbon group having 2 to 100 carbon atoms, preferably, a hydrocarbon group having 2 to 50 carbon atoms, further preferably, a hydrocarbon group having 2 to 40 carbon atoms.

A description "in the formulas (2a) and (4), X is each independently" means that, in the formulas, X present in two of arbitrary formulas may be identical or different. The rule also applies to a description using any other formula.

In the formulas (2a), (3) and (6), Y is each independently an organic group having 1 to 100 carbon atoms. Specific examples of the organic group having 1 to 100 carbon atoms include a hydrocarbon group having 1 to 100 carbon atoms, preferably, a hydrocarbon group having 1 to 50 carbon atoms, further preferably, a hydrocarbon group having 1 to 40 carbon atoms.

In the formula (5), Z is an organic group having 1 to 100 carbon atoms. Specific examples of the organic group having 1 to 100 carbon atoms include a hydrocarbon group having 1 to 100 carbon atoms, preferably, a hydrocarbon group having 1 to 50 carbon atoms, further preferably, a hydrocarbon group having 1 to 40 carbon atoms.

In the formulas (2b), (3) and (5), X' is each independently an organic group having 1 to 100 carbon atoms, preferably, an organic group having an unsaturated hydrocarbon group and having 2 to 100 carbon atoms, or an organic group represented by formula (α) described below. Specific examples of the organic group having 1 to 100 carbon atoms include a hydrocarbon group having 1 to 100 carbon atoms, preferably, a hydrocarbon group having 1 to 50 carbon atoms, further preferably, a hydrocarbon group having 1 to 40 carbon atoms.

Specific examples of the unsaturated hydrocarbon group herein include alkenyl, alkynyl, cycloalkynyl, alkenylene, alkynylene, cycloalkenylene, alkyldienyl, acryl and methacryl.

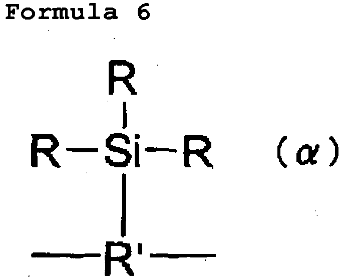

In the formula (α), R is independently hydrogen, alkyl having 1 to 20 carbon atoms or alkoxy having 1 to 20 carbon atoms, and at least one of R is preferably alkoxy.

R' in the formula (α) is an organic group having 1 to 20 carbon atoms. Specific examples of the organic group having 1 to 20 carbon atoms include a hydrocarbon group having 1 to 20 carbon atoms.

The compound represented by the formula (3) has a plurality of X'. In this case, two of arbitrary X' may be identical or different. The rule also applies to a description using any other formula.

In the formulas (2c), (4) and (6), Y' is each independently an organic group having 1 to 100 carbon atoms, preferably, an organic group having an unsaturated hydrocarbon group and having 2 to 100 carbon atoms, or an organic group represented by formula (β) described below. Specific examples of the organic group having 1 to 100 carbon atoms include a hydrocarbon group having 1 to 100 carbon atoms, preferably, a hydrocarbon group having 1 to 50 carbon atoms, further preferably, a hydrocarbon group having 1 to 40 carbon atoms.

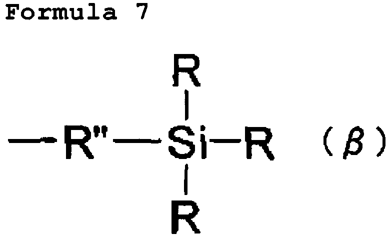

In the formula (β), R is independently hydrogen, alkyl having 1 to 20 carbon atoms or alkoxy having 1 to 20 carbon atoms, and at least one of R is preferably alkoxy.

R" in the formula (β) is an organic group having 1 to 20 carbon atoms. Specific examples of the organic group having 1 to 20 carbon atoms include a hydrocarbon group having 1 to 20 carbon atoms.

In the hydrocarbon group herein, arbitrary -CH₂- of the hydrocarbon group may be replaced by -O-, -CO-, -COO-, -OCO-, -NR-(wherein R is hydrogen, methyl, ethyl, ethoxy or methoxy), -CONH-, -NHCO-, -S-, -S-S-, -SO₂-, -SiRR'- (wherein R and R' are each independently hydrogen, methyl, ethyl, propyl or phenyl) or >P(=O)R (wherein R is hydrogen, methyl, ethyl, hydroxyl, ethoxy or methoxy), arbitrary -(CH₂)₂- may be replaced by -CH=CH-, -C=Cor -N=N-, and arbitrary hydrogen may be replaced by halogen.

The hydrocarbon group herein may be a saturated or unsaturated acyclic hydrocarbon group, a saturated or unsaturated cyclic hydrocarbon group, and a group including both of the acyclic hydrocarbon group and the cyclic hydrocarbon group. The acyclic hydrocarbon group may have a straight chain or a branched chain.

Moreover, an arbitrary carbon atom constituting a ring may be replaced by an oxygen atom, a nitrogen atom, a sulfur atom or P(=O). Specifically, arbitrary -CH₂- constituting the ring may be replaced by -O-, -N=, -S-, or >P(=O)R (wherein R is hydrogen, methyl, ethyl, hydroxyl, ethoxy or methoxy), and arbitrary -CH=CH- may be replaced by -N=N- or -CH=N-.

"Arbitrary" used in the invention means any of numbers and also positions, but replacement of a plurality of consecutive -CH₂-, -(CH₂)₂- or the like by an identical group is not preferred. A substituent having an unclear bonding position with carbon constituting the ring means that a bonding position is free within the range in which the bonding position causes no chemical problem.

Hereafter, unless otherwise noted herein, the definitions of symbols such as X and Y in a constitutional unit, a group and a compound represented by identical symbols such as (2a) and (3) are identical.

In addition, specific examples of a monovalent hydrocarbon group will be shown below. Specific examples of a divalent, trivalent or tetravalent hydrocarbon group herein include a divalent, trivalent or tetravalent hydrocarbon group derived from the groups in a hydrocarbon group shown below as an example.

Specific examples of the hydrocarbon group include alkyl, alkenyl, alkynyl, alkyldienyl, aryl, alkylaryl, arylalkyl, cycloalkyl, cycloalkenyl, alkoxy, aryloxy, amino, silyl, alkylthio, alkylsulfonyl, arylthio and arylsulfonyl.

Specific examples of the alkyl include methyl, ethyl, propyl, isopropyl, n-butyl, sec-butyl, tert-butyl, pentyl, hexyl and dodecanyl.

Specific examples of the alkenyl include vinyl, allyl, propenyl, isopropenyl, 2-methyl-1-propenyl, 2-methylallyl and 2-butenyl.

Specific examples of the alkynyl include ethynyl, propynyl and butynyl.

Specific examples of the alkyldienyl include 1,3-butadienyl.

Specific examples of the aryl include phenyl, 1-naphthyl, 2-naphthyl, indenyl, biphenylyl, anthryl and phenanthryl.

Specific examples of the alkylaryl include o-tolyl, m-tolyl, p-tolyl, 2,3-xylyl, 2,4-xylyl, 2,5-xylyl, o-cumenyl, m-cumenyl, p-cumenyl and mesityl.

Specific examples of the arylalkyl include benzyl, phenethyl, diphenylmethyl, triphenylmethyl, 1-naphthylmethyl, 2-naphthylmethyl, 2,2-diphenylethyl, 3-phenylpropyl, 4-phenylbutyl and 5-phenylpentyl.

Specific examples of the cycloalkyl include cyclopropyl, cyclobutyl, cyclopentyl and cyclohexyl.

Specific examples of the cycloalkenyl include cyclopropenyl, cyclobutenyl, cyclopentenyl and cyclohexenyl.

Specific examples of the alkoxy include ethoxy, propoxy, butoxy and pentyloxy.

Specific examples of the aryloxy include phenyloxy, naphthyloxy and biphenyloxy.

Specific examples of the amino include amino, dimethylamino, methylamino, methylphenylamino and phenylamino.

Specific examples of the silyl include dimethylsilyl, diethylsilyl, trimethylsilyl, triethylsilyl, trimethoxysilyl, triethoxysilyl, diphenylmethylsilyl, triphenylsilyl, triphenoxysilyl, dimethylmethoxysilyl and dimethylphenoxysilyl.

Specific examples of the alkyl in the alkylthio and the alkylsulfonyl include methyl, ethyl, propyl, isopropyl, n-butyl, sec-butyl, tert-butyl, pentyl, hexyl and dodecanyl.

Specific examples of the aryl in the arylthio and the arylsulfonyl include phenyl, 1-naphthyl, 2-naphthyl, indenyl, biphenylyl, anthryl and phenanthryl.

In addition, compound (2) is a polyamide acid derivative having a constitutional unit represented by the formula (2a) and at least one kind of molecular terminal group selected from the group of groups represented by the formulas (2b) and (2c).

The molecular terminal group is a group present at a (main chain) terminal of compound (2).

The constitutional unit represented by the formula (2a) can be obtained by allowing diamine to react with tetracarboxylic dianhydride as described later, for example.

Moreover, the molecular terminal group represented by the formula (2b) can be obtained by allowing diamine to react with dicarboxylic anhydride as described later, for example.

Furthermore, the molecular terminal group represented by the formula (2c) can be obtained by allowing monoamine to react with tetracarboxylic dianhydride as described later, for example.

Compound (2) is not particularly limited, if compound (2) is a compound that is chemically allowed. Specific examples include; (I) a compound in which either one of two terminals in the main chain is a group represented by the formula (2b) or a group represented by the formula (2c) ; (II) a compound in which both of two terminals in the main chain are a group represented by the formula (2b) or a group represented by the formula (2c) ; and (III) a compound in which one of two terminals in the main chain is a group represented by the formula (2b) and the other is a group represented by the formula (2c).

Among the compounds, the compound (2) is preferably at least one kind of compound selected from the group of compounds represented by formula (2-1) to formula (2-3) described below.

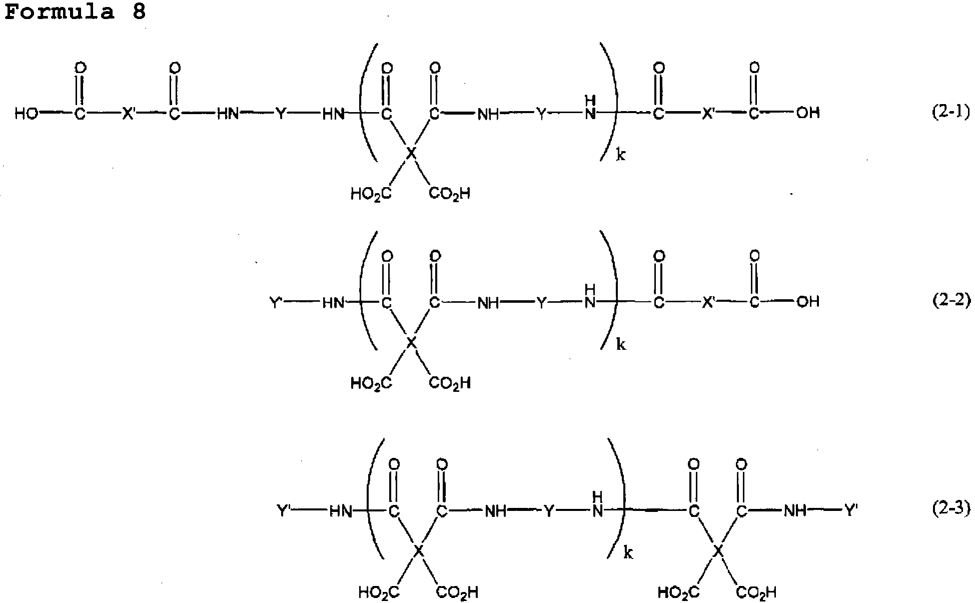

In the formula (2-1) to formula (2-3), X is each independently defined in a manner identical with X in the formulas (2a) and (4), in the formula (2-1) to formula (2-3), Y is each independently defined in a manner identical with Y in the formulas (2a), (3) and (6), in the formula (2-1) to formula (2-2), X' is each independently defined in a manner identical with X' in the formulas (2b), (3) and (5), and in the formulas (2-2) and (2-3), Y' is each independently defined in a manner identical with Y' in the formulas (2c), (4) and (6).

In the formula (2-1) to formula (2-3), k is each independently an integer from 1 to 8, preferably, an integer from 1 to 5, further preferably, an integer from 1 to 3.

Specific examples of the amide acid derivative (A1) include a compound obtained by using diamine and a compound having two or more acid anhydride groups. Preferred examples include a polyamide acid having a constitutional unit represented by formula (2a) described below and having at least one kind of molecular terminal group selected from the group of groups represented by formula (2b) and formula (2c) described below according to JP 2009-35700 A.

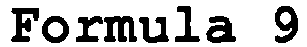

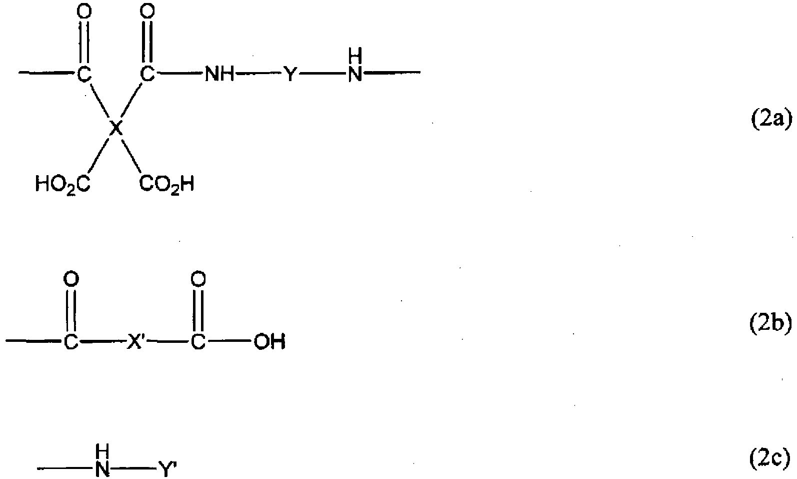

Specific examples of the amide acid derivative (A1) also include a compound having at least one amide acid structure in a molecule. Preferred examples include a compound represented by formula (3) or formula (4) described below according to WO 2008/123190 A, and a compound represented by formula (6) described below according to JP 2009-144138 A.

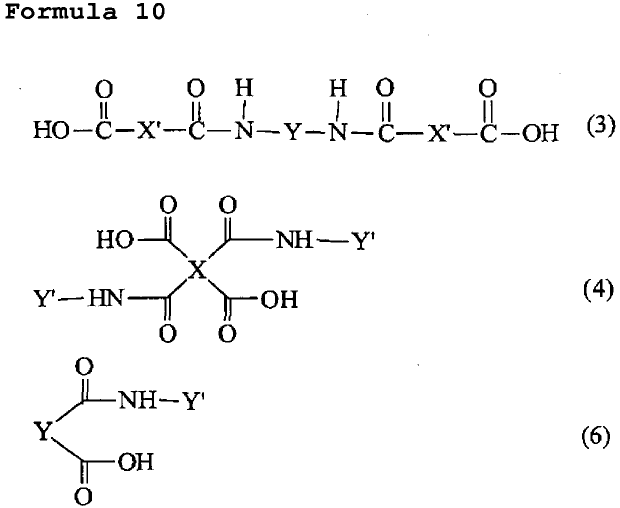

### 1.1-2. Imide compound (A2)

The imidized substance (A2) is an imidized substance of the amide acid derivative (A1). The imidized substance (A2) may be a compound in which the amide acid derivative (A1) is completely or partially imidized.

Specific examples of the imidized substance (A2) include an imidized substance of a compound represented by formula (3) described below, and an alkenyl-substituted nadimide compound having at least one alkenyl-substituted nadimide structure in a molecule.

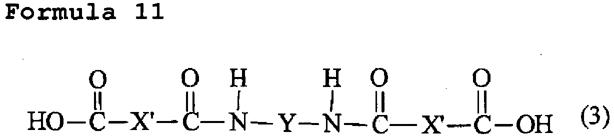

Preferred examples of the alkenyl-substituted nadimide compound include an alkenyl-substituted nadimide compound represented by formula (7) described below according to WO 2008/059986 A, and an alkenyl-substituted nadimide compound according to JP 2009-203440 A.

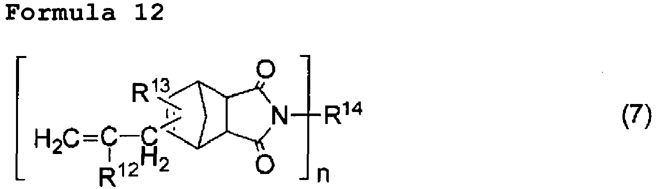

In the formula (7), R¹² and R¹³ are each independently hydrogen, alkyl having 1 to 12 carbon atoms, alkenyl having 3 to 6 carbon atoms, cycloalkyl having 5 to 8 carbon atoms, or aryl having 6 to 12 carbon atoms or benzyl, and n is 1 or 2.

When n in the formula (7) is 1, R¹⁴ is hydrogen, alkyl having 1 to 12 carbon atoms, hydroxyalkyl having 1 to 12 carbon atoms, cycloalkyl having 5 to 8 carbon atoms, aryl having 6 to 12 carbon atoms, benzyl, a group represented by -{(C_{q}H_{2q})Oₜ(CᵣH₂ᵣO)ᵤCₛH₂ₛX} (wherein q, r and s are each independently an integer from 2 to 6, t is an integer of 0 or 1, u is an integer from 1 to 30, and X is hydrogen or hydroxyl), a group represented by -(R)ₐ-Ph-R¹⁵ (wherein a is an integer of 0 or 1, R is alkylene having 1 to 4 carbon atoms, and R¹⁵ is hydrogen or alkyl having 1 to 4 carbon atoms), a group represented by -Ph-T-Ph (wherein T is -CH₂-, -C(CH₃)₂-, -CO-, -S- or -SO₂-), or a group in which one to three of hydrogen bonded with an aromatic ring (Ph) in the group are replaced by hydroxyl. Ph herein represents phenyl or phenylene.

When n in the formula (7) is 2, R¹⁴ is alkylene represented by -CₚH₂ₚ- (wherein p is an integer from 2 to 20), cycloalkylene having 5 to 8 carbon atoms, a group represented by -{(C_{q}H_{2q}O)ₜ(CᵣH₂ᵣO)ᵤCₛH₂ₛ}- (wherein q, r and s are each independently an integer from 2 to 6, t is an integer of 0 or 1, and u is an integer from 1 to 30), arylene having 6 to 12 carbon atoms, a group represented by -(R¹⁵)ₐ-Ph-R¹⁶- (wherein a is an integer of 0 or 1, and R¹⁵ and R¹⁶ are each independently alkylene having 1 to 4 carbon atoms), a group represented by -Ph-T-Ph-(wherein T is -CH₂-, -C(CH₃)₂-, -CO-, -O-, -O-Ph-C(CH₃)₂-Ph-O-, -S- or -SO₂-), or a group in which one to three of hydrogen bonded with an aromatic ring (Ph) in the groups are replaced by hydroxyl.

### 1.1-3. Method for synthesizing amide acid derivative (A1) or imidized substance (A2)

The amide acid derivative (A1) can be obtained preferably by allowing at least one kind of amine selected from the group of diamine represented by formula (9) described below and monoamine represented by formula (11) described below to react with at least one kind of acid anhydride selected from the group of tetracarboxylic dianhydride represented by formula (8) described below and dicarboxylic anhydride represented by formula (10) described below.

The reaction is preferably carried out under a reaction solvent described below.

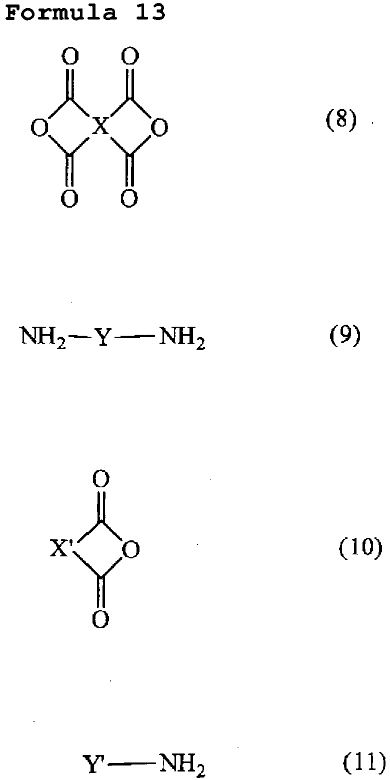

X in the formula (8) is defined in a manner identical with X in the formulas (2a) and (4), Y in the formula (9) is defined in a manner identical with Y in the formulas (2a), (3) and (6), X' in the formula (10) is defined in a manner identical with X' in the formulas (2b), (3) and (5), and Y' in the formula (11) is defined in a manner identical with Y' in the formulas (2c), (4) and (6).

### 1.1-3-1. Tetracarboxylic dianhydride

Specific examples of the tetracarboxylic dianhydride represented by the formula (8) include pyromellitic dianhydride, 3,3',4,4'-benzophenone tetracarboxylic dianhydride, 2,2',3,3'-benzophenone tetracarboxylic dianhydride, 2,3,3',4'-benzophenone tetracarboxylic dianhydride, 3,3',4,4'-diphenylsulfone tetracarboxylic dianhydride, 2,2',3,3'-diphenylsulfone tetracarboxylic dianhydride, 2,3,3',4'-diphenylsulfone tetracarboxylic dianhydride, 3,3',4,4'-diphenylether tetracarboxylic dianhydride (abbreviation: ODPA), 2,2',3,3'-diphenylether tetracarboxylic dianhydride, 2,3,3',4'-diphenylether tetracarboxylic dianhydride, 2,2-[bis(3,4-dicarboxyphenyl)]hexafluoropropane dianhydride, ethyleneglycol bis(anhydrotrimellitate), cyclobutane tetracarboxylic dianhydride, methylcyclobutane tetracarboxylic dianhydride, cyclopentane tetracarboxylic dianhydride, 1,2,4,5-cyclohexane tetracarboxylic dianhydride, ethane tetracarboxylic dianhydride, butane tetracarboxylic dianhydride, 3,3',4,4'-biphenyl tetracarboxylic dianhydride (BPDA) and 3,3',4,4'-bicyclohexyl tetracarboxylic dianhydride (BPDA-H).

Among these, the tetracarboxylic dianhydride is preferably ODPA or BPDA-H in view of solubility of the resultant ink in a solvent described below (containing solvent (B), and if necessary, solvent (B')), and so forth.

The tetracarboxylic dianhydride may be used alone or in combination of two or more kinds.

### 1.1-3-2. Diamine

Specific examples of the diamine represented by the formula (9) include 3,3'-diaminodiphenyl sulfone, 4,4'-diaminodiphenyl ether, 3,3'-diaminodiphenyl methane, 4,4'-diaminodiphenyl methane, 2,2'-diaminodiphenyl propane, 3,3'-dimethyl-4,4'-diaminodiphenyl methane, 2,2-bis[4-(4-aminophenoxy)phenyl]propane (abbreviation: BAPP), 2,2-bis[4-(4-aminophenoxy)phenyl]hexafluoropropane, m-phenylenediamine, p-phenylenediamine, m-xylylenediamine, p-xylylenediamine, benzidine, 1,1-bis[4-(4-aminophenoxy)phenyl]cyclohexane, 1,1-bis[4-(4-aminophenoxy)phenyl]-4-methylcyclohexane, 1,1-bis[4-(4-aminobenzyl)phenyl]cyclohexane, 1,1-bis[4-(4-aminobenzyl)phenyl]-4-methylcyclohexane, 1,1-bis[4-(4-aminobenzyl)phenyl]methane, 1,3-bis(4-aminophenoxy)benzene, diethylene glycol bis(3-aminopropylether (abbreviation: BAPEE) and a compound represented by formula (13) described below.

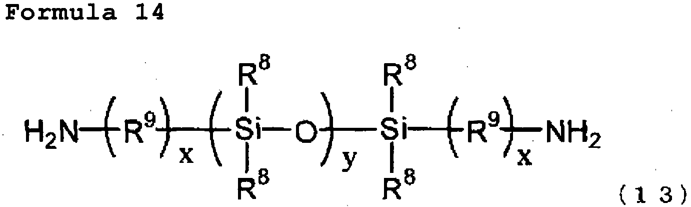

In the formula (13), R⁸ is independently alkyl having 1 to 3 carbon atoms or phenyl, R⁹ is independently methylene or phenylene, arbitrary hydrogen of the phenylene may be replaced by alkyl, x is independently an integer from 1 to 6, and y is an integer from 1 to 70.

Among these, the diamine is preferably BAPP or BAPEE in view of solubility of the resultant ink in a solvent described below (containing solvent (B), and if necessary, solvent (B')), and so forth.

The diamine may be used alone or in combination of two or more kinds.

### 1.1-3-3. Dicarboxylic anhydride

Specific examples of the dicarboxylic anhydride represented by the formula (10) include phthalic anhydride, trimellitic anhydride, 3-methylphthalic anhydride, 4-methylphthalic anhydride, 4-tert-butylphthalic anhydride, 3-fluorophthalic anhydride, 4-fluorophthalic anhydride, 4-ethynylphthalic anhydride, 4-phenylethynylphthalic anhydride, tetrafluorophthalic anhydride, succinic anhydride, butylsuccinic anhydride, n-octylsuccinic anhydride, dodecylsuccinic anhydride, tetrapropenylsuccinic anhydride, tetradecenylsuccinic anhydride, octadecenylsuccinic anhydride, allylsuccinic anhydride, 2-butene-1-yl-succinic anhydride, 2-dodecene-1-yl-succinic anhydride, maleic anhydride (abbreviation: MA), 2,3-dimethylmaleic anhydride, glutaric anhydride, itaconic anhydride, citraconic anhydride, allylnadic anhydride, cis-1,2-cyclohexanedicarboxylic anhydride, 4-methylcyclohexane-1,2-dicarboxylic anhydride, cis-4-cyclohexene-1,2-dicarboxylic anhydride, methylcyclohexene-1,2-dicarboxylic anhydride, 5-norbornene-2,3-dicarboxylic anhydride, 1,3-cyclohexanedicarboxylic anhydride, p-(trimethoxysilyl)phenylsuccinic anhydride, p-(triethoxysilyl)phenylsuccinic anhydride, m-(trimethoxysilyl)phenylsuccinic anhydride, m-(triethoxysilyl)phenylsuccinic anhydride, trimethoxysilylpropylsuccinic anhydride, and triethoxysilylpropylsuccinic anhydride (abbreviation: TESA).

Among these, the dicarboxylic anhydride is preferably phthalic anhydride, trimellitic anhydride, 4-methylphthalic anhydride, 4-tert-butylphthalic anhydride, 4-fluorophthalic anhydride, tetrafluorophthalic anhydride, tetrapropenylsuccinic anhydride, tetradecenylsuccinic anhydride, octadecenylsuccinic anhydride, 2-dodecene-1-yl-succinic anhydride, glutaric anhydride, itaconic anhydride, citraconic anhydride, allylnadic anhydride, cis-1,2-cyclohexanedicarboxylic anhydride, 4-methylcyclohexane-1, 2-dicarboxylic anhydride, cis-4-cyclohexene-1,2-dicarboxylic anhydride, 5-norbornene-2,3-dicarboxylic anhydride, MA, TESA, and 1,3-cyclohexanedicarboxylic anhydride.

Among these, the dicarboxylic anhydride is preferably MA, TESA, citraconic anhydride or allylnadic anhydride in view of solubility of the resultant ink in a solvent described below (containing solvent (B), and if necessary, solvent (B')), further preferably, MA in view of handling easiness, and so forth.

The dicarboxylic anhydride may be used alone or in combination of two or more kinds.

### 1.1-3-4. Monoamine

Specific examples of the monoamine represented by the formula (11) include 3-aminopropyltrimethoxysilane, 3-aminopropyltriethoxysilane, 3-aminopropylmethyldimethoxysilane, 3-aminopropylmethyldiethoxysilane, 4-aminobutyltrimethoxysilane, 4-aminobutyltriethoxysilane, 4-aminobutylmethyldiethoxysilane, p-aminophenyltrimethoxysilane, p-aminophenyltriethoxysilane, p-aminophenylmethyldimethoxysilane, p-aminophenylmethyldiethoxysilane, m-aminophenyltrimethoxysilane, m-aminophenylmethyldiethoxysilane, 4-ethynylaniline, 3-ethynylaniline, propargylamine, 3-aminobutyne, 4-aminobutyne, 5-aminopentyne, 4-aminopentyne, allylamine, 7-aminoheptyne, m-aminostyrene, p-aminostyrene, m-amino-α-methylstyrene, 3-aminophenylacetylene and 4-aminophenylacetylene.

Among these, the monoamine is preferably 3-aminopropyltrimethoxysilane, 3-aminopropylmethyldiethoxysilane, 3-aminopropyltriethoxysilane and p-aminophenyltrimethoxysilane, particularly preferably, 3-aminopropyltriethoxysilane in view of an excellent durability of the resultant polyimide film, for example.

The monoamine may be used alone or in combination of two or more kinds.

### 1.1-3-5. Method for synthesizing amide acid derivative (A1)

Specific examples of methods for preparing the amide acid derivative (A1) include the methods described in the Patent literatures 6 to 10.

The amide acid derivative (A1) can be obtained by allowing diamine and/or monoamine to react with tetracarboxylic dianhydride and/or dicarboxylic anhydride under mild reaction conditions in which an amino group and an acid anhydride group react to form amide acid.

"Mild reaction conditions" means conditions in which the reaction is allowed under a normal pressure, a temperature in the range of 20 to 60°C, and a reaction time in the range of 0.2 to 20 hours, without using a catalyst and without activating a carboxyl group caused by opening a ring of the acid anhydride group by the reaction, for example. An expression "activating the carboxyl group" means conversion of the carboxyl group into acid chloride, for example.

Under such mild reaction conditions, the carboxyl group caused by the reaction of the amino group with the acid anhydride group does not further react with the amino group of the diamine and/or the monoamine. Therefore, amide acid derivative (A1) having a free carboxyl group is obtained.

### 1.1-3-6. Method for synthesizing imidized substance (A2)

The imidized substance (A2) can be obtained by imidizing the amide acid derivative (A1). Specific examples include a method for imidizing the amide acid derivative according to a thermal method or a chemical method using a dehydration catalyst or a dehydrating agent. Preferred methods include the method for imidizing the amide acid derivative according to the thermal method in view of allowing use as a component of the ink without carrying out purification treatment, and so forth. Further preferred methods include the method for imidizing the amide acid derivative by the reaction of raw materials such as the tetracarboxylic dianhydride, the diamine, the dicarboxylic anhydride and the monoamine in the reaction solvent, and then carrying out reflux. The reflux is preferably carried out under conditions of 1.5 to 10 hours at 140 to 230°C, although the conditions are different depending on the reaction solvent to be used. If a reflux temperature is within the range described above, imidization fully progresses. Therefore, the ink containing the resultant imidized substance can form a tough polyimide film.

### 1.1-3-7. Reaction solvent

The reaction solvent that can be used upon preparing the amide acid derivative (A1) or the imidized substance (A2) thereof is not particularly limited, but is preferably a solvent that can easily dissolve the amide acid derivative (A1), the imidized substance (A2), and raw material compounds to be used upon preparing the amide acid derivative (A1) and the imidized substance (A2).

Moreover, a solution obtained after preparing the amide acid derivative (A1) or the imidized substance (A2) is preferably used directly as the ink of the invention, or if necessary, used as the ink of the invention by further adding an additive described below to the solution. Therefore, as the reaction solvent, such a solvent is preferably used in which the resultant solution obtained after preparing the amide acid derivative (A1) or the imidized substance (A2) has an excellent storage stability and jettability and can form a desired shape of polyimide film easily (hereinafter, referred to also as patternability).

Specific examples of the reaction solvent include amide-based solvent (B) and solvent (B') described below. A solvent containing the amide-based solvent (B) is preferably used in view of allowing obtaining of an ink having an excellent storage stability, jettability and patternability, and so forth.

Among types of the reaction solvents, the reaction solvent is preferably Equamide (trade name; Idemitsu Kosan Co., Ltd.), propylene glycol monomethyl ether acetate, methyl 3-methoxypropionate, cyclohexanone, diethylene glycol methyl ethyl ether, diethylene glycol dimethyl ether and γ-butyrolactone in view of allowing easy dissolution of the amide acid derivative (A1), the imidized substance (A2) and the raw material compounds used upon preparing the amide acid derivative (A1) and the imidized substance (A2).

The reaction solvent may be used alone or in combination of two or more kinds.

If the reaction solvent is used in an amount of 100 parts by weight or more based on 100 parts by weight of the total of the raw material compounds to be used for preparing the amide acid derivative (A1) or the imidized substance (A2), the relevant synthetic reaction progresses smoothly, and therefore such use is preferred.

### 1.1-4. Weight average molecular weight of amide acid derivative (A1) or imidized substance (A2)

As the amide acid derivative (A1) or the imidized substance (A2), a compound having a weight average molecular weight in the range of 300 to 12, 000 is preferably used in view of an excellent solubility in amide-based solvent (B) described below, and so forth. The weight average molecular weight of the amide acid derivative (A1) and the imidized substance (A2) is further preferably in the range of 400 to 9,000, particularly preferably, in the range of 450 to 7,000 from a viewpoint of solubility of the amide acid derivative (A1) or the imidized substance (A2) in the amide-based solvent (B).

If a compound having a weight average molecular weight of 300 or more is used, a chemically and mechanically stable polyimide film is obtained. Moreover, a compound having a weight average molecular weight of 12, 000 or less has a particularly high solubility in amide-based solvent (B), and therefore the concentration of component (A) in the ink of the invention can be increased. Thus, flexibility and heat resistance of the polyimide film obtained from the ink can be improved.

The weight average molecular weight of the amide acid derivative (A1) and the imidized substance (A2) can be measured according to a gel permeation chromatography (GPC) method.

For example, the amide acid derivative (A1) or the imidized substance (A2) is mixed with N,N-dimethylformamide (DMF) to prepare a solution having a concentration of about 1% by weight of the amide acid derivative (A1) or the imidized substance (A2). Then, the weight average molecular weight can be determined by the GPC method by using the solution, using columns prepared by combining G4000HXL, G3000HXL, G2500HXL and G2000HXL made by Tosoh Corporation in series in the order as a column, under conditions of a column temperature of 40°C and a flow rate of 1.0 ml/min, and using DMF as a developer, and then calculating a polystyrene-equivalent weight average molecular weight.

### 1.1-5. Content of component (A)

The content of component (A) in the ink of the invention is preferably in the range of 5 to 95% by weight, further preferably, in the range of 20 to 80% by weight, based on 100% by weight of the ink.

If the content of component (A) in the ink of the invention is in the range described above, an ink having an excellent jettability can be obtained.

The ink of the invention contains amide-based solvent (B). Therefore, the content of component (A) in the ink can be increased. Formation of a thick polyimide film is required depending on an application. Therefore, in this case, as the concentration of component (A) in the ink of the invention is higher, the thickness of the polyimide film obtained from the ink becomes larger, and therefore a higher concentration is preferred.

Moreover, even when the content of component (A) in the ink is increased, the ink of the invention can be jetted in an inkjet coater.

According to the ink of the invention, the content of component (A) in the ink can be easily changed depending on a desired application. Therefore, a thin polyimide film to a thick polyimide film can be easily formed by single jetting by means of the inkjet coater.

### 1.2. Solvent

The ink of the invention is an inkjet ink containing amide-based solvent (B) having a specific structure, and if necessary, may further contain solvent (B'). If such a solvent is used, an ink having a good storage stability, jettability and patternability is composed, and an ink hardly causing degradation of an inkjet head, and so forth is obtained.

### 1.2-1. Amide-based solvent (B)

The amide-based solvent (B) is a solvent represented by formula (1) described below.

The amide-based solvent (B) can easily dissolve component (A). Moreover, the amide-based solvent (B) can more easily dissolve component (A), as compared with a solvent that has been used so far for dissolving the amide acid derivative or the imidized substance thereof, such as 1-methyl-2-pyrrolidone, N,N-dimethylacetamide, N,N-diethylacetamide and N,N-dimethylpropionamide.

In a case where a compound prepared using maleic acid or a derivative thereof as a raw material is used as component (A), the compound is poorly dissolved in the solvent that has been used so far, in many cases. Therefore, in the case where the compound is used as component (A), an advantage of using the amide-based solvent (B) is particularly significant.

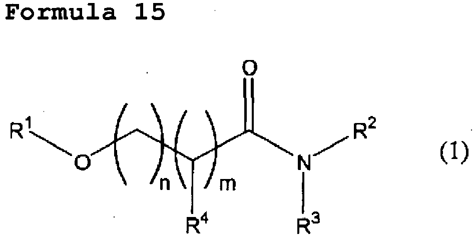

In the formula (1), R¹ is an organic group having 1 to 18 carbon atoms. Specific examples of the organic group having 1 to 18 carbon atoms include a hydrocarbon group having 1 to 18 carbon atoms, preferably, a hydrocarbon group having 1 to 10 carbon atoms, further preferably, alkyl having 1 to 8 carbon atoms. Among these, methyl, ethyl, propyl, isopropyl, n-butyl, sec-butyl, pentyl, cyclopentyl, hexyl or cyclohexyl is preferable, and further preferably, methyl or n-butyl is further preferable.

In the formula (1), R² and R³ satisfy requirement (i) or (ii) described below.
(i)_{:} R² and R³ are each independently hydrogen or an organic group having 1 to 6 carbon atoms.
(ii): R² and R³ are bonded with each other to form a ring structure.

Specific examples of the organic group having 1 to 6 carbon atoms in the requirement (i) include a hydrocarbon group having 1 to 6 carbon atoms. Preferred examples of the hydrocarbon group having 1 to 6 carbon atoms include a hydrocarbon group having 1 to 6 carbon atoms that may have an ether bond. Among types of the hydrocarbon group, the hydrocarbon group is preferably methyl, ethyl, propyl, isopropyl, n-butyl, sec-butyl or tert-butyl, further preferably, methyl.

Specific examples of the ring structure (-NR²R³) in the requirement (ii) include pyrrolidinyl and piperidinyl.

In the formula (1), R⁴ is hydrogen or methyl, preferably, hydrogen.

In the formula (1), n is an integer from 0 to 3, and m is 0 or 1. Then, a sum of n and m is preferably an integer from 1 to 3, further preferably, 2.

Specific examples of the amide-based solvent (B) include 3-methoxy-N,N-dimethylpropionamide (abbreviation: DMMP), 3-ethoxy-N,N-dimethylpropionamide, 3-n-propoxy-N,N-dimethylpropionamide, 3-isopropoxy-N,N-dimethylpropionamide, 3-n-butoxy-N,N-dimethylpropionamide, 3-sec-butoxy-N,N-dimethylpropionamide, 3-pentyloxy-N,N-dimethylpropionamide, 3-cyclopentyloxy-N,N-dimethylpropionamide, 3-hexyloxy-N,N-dimethylpropionamide, 3-cyclohexyloxy-N,N-dimethylpropionamide, 3-methoxy-N,N-diethylpropionamide, 3-ethoxy-N,N-diethylpropionamide, 3-n-propoxy-N,N-diethylpropionamide, 3-isopropoxy-N,N-diethylpropionamide, 3-n-butoxy-N,N-diethylpropionamide, 3-sec-butoxy-N,N-diethylpropionamide, 3-pentyloxy-N,N-diethylpropionamide, 3-cyclopentyloxy-N,N-diethylpropionamide, 3-hexyloxy-N,N-diethylpropionamide, 3-cyclohexyloxy-N,N-diethylpropionamide, 3-methoxy-N,N-dipropylpropionamide, 3-ethoxy-N,N-dipropylpropionamide, 3-n-propoxy-N,N-dipropylpropionamide, 3-isopropoxy-N,N-dipropylpropionamide, 3-n-butoxy-N,N-dipropylpropionamide, 3-sec-butoxy-N,N-dipropylpropionamide, 3-pentyloxy-N,N-dipropylpropionamide, 3-cyclopentyloxy-N,N-dipropylpropionamide, 3-hexyloxy-N,N-dipropylpropionamide and 3-cyclohexyloxy-N,N-dipropylpropionamide.

The specific examples also include 3-methoxy-2-methyl-N,N-dimethylpropionamide, 3-ethoxy-2-methyl-N,N-dimethylpropionamide, 3-n-propoxy-2-methyl-N,N-dimethylpropionamide, 3-isopropoxy-2-methyl-N,N-dimethylpropionamide, 3-n-butoxy-2-methyl-N,N-dimethylpropionamide, 3-sec-butoxy-2-methyl-N,N-dimethylpropionamide, 3-pentyloxy-2-methyl-N,N-dimethylpropionamide, 3-cyclopentyloxy-2-methyl-N,N-dimethylpropionamide, 3-hexyloxy-2-methyl-N,N-dimethylpropionamide, 3-cyclohexyloxy-2-methyl-N,N-dimethylpropionamide, 3-methoxy-2-methyl-N,N-diethylpropionamide, 3-ethoxy-2-methyl-N,N-diethylpropionamide, 3-n-propoxy-2-methyl-N,N-diethylpropionamide, 3-isopropoxy-2-methyl-N,N-diethylpropionamide, 3-n-butoxy-2-methyl-N,N-diethylpropionamide, 3-sec-butoxy-2-methyl-N,N-diethylpropionamide, 3-pentyloxy-2-methyl-N,N-diethylpropionamide, 3-cyclopentyloxy-2-methyl-N,N-diethylpropionamide, 3-hexyloxy-2-methyl-N,N-diethylpropionamide, 3-cyclohexyloxy-2-methyl-N,N-diethylpropionamide, 3-methoxy-2-methyl-N,N-dipropylpropionamide, 3-ethoxy-2-methyl-N,N-dipropylpropionamide, 3-n-propoxy-2-methyl-N,N-dipropylpropionamide, 3-isopropoxy-2-methyl-N,N-dipropylpropionamide, 3-n-butoxy-2-methyl-N,N-dipropylpropionamide, 3-sec-butoxy-2-methyl-N,N-dipropylpropionamide, 3-pentyloxy-2-methyl-N,N-dipropylpropionamide, 3-cyclopentyloxy-2-methyl-N,N-dipropylpropionamide, 3-hexyloxy-2-methyl-N,N-dipropylpropionamide and 3-cyclohexyloxy-2-methyl-N,N-dipropylpropionamide.

The specific examples further include 2-methoxy-N,N-dimethyl acetic acid amide, 2-ethoxy-N,N-dimethyl acetic acid amide, 2-n-propoxy-N,N-dimethyl acetic acid amide, 2-isopropoxy-N,N-dimethyl acetic acid amide, 2-n-butoxy-N,N-dimethyl acetic acid amide, 2-sec-butoxy-N,N-dimethyl acetic acid amide, 2-pentyloxy-N,N-dimethyl acetic acid amide, 2-cyclopentyloxy-N,N-dimethyl acetic acid amide, 2-hexyloxy-N,N-dimethyl acetic acid amide, 2-cyclohexyloxy-N,N-dimethyl acetic acid amide, 2-methoxy-N,N-diethyl acetic acid amide, 2-ethoxy-N,N-diethyl acetic acid amide, 2-n-propoxy-N,N-diethyl acetic acid amide, 2-isopropoxy-N,N-diethyl acetic acid amide, 2-n-butoxy-N,N-diethyl acetic acid amide, 2-sec-butoxy-N,N-diethyl acetic acid amide, 2-pentyloxy-N,N-diethyl acetic acid amide, 2-cyclopentyloxy-N,N-diethyl acetic acid amide, 2-hexyloxy-N,N-diethyl acetic acid amide, 2-cyclohexyloxy-N,N-diethyl acetic acid amide, 2-methoxy-N,N-dipropyl acetic acid amide, 2-ethoxy-N,N-dipropyl acetic acid amide, 2-n-propoxy-N,N-dipropyl acetic acid amide, 2-isopropoxy-N,N-dipropyl acetic acid amide, 2-n-butoxy-N,N-dipropyl acetic acid amide, 2-sec-butoxy-N,N-dipropyl acetic acid amide, 2-pentyloxy-N,N-dipropyl acetic acid amide, 2-cyclopentyloxy-N,N-dipropyl acetic acid amide, 2-hexyloxy-N,N-dipropyl acetic acid amide and 2-cyclohexyloxy-N,N-dipropyl acetic acid amide.

The specific examples furthermore include 1-methoxy-N,N-dimethyl formic acid amide, 1-ethoxy-N,N-dimethyl formic acid amide, 1-n-propoxy-N,N-dimethyl formic acid amide, 1-isopropoxy-N,N-dimethyl formic acid amide, 1-n-butoxy-N,N-dimethyl formic acid amide, 1-sec-butoxy-N,N-dimethyl formic acid amide, 1-pentyloxy-N,N-dimethyl formic acid amide, 1-cyclopentyloxy-N,N-dimethyl formic acid amide, 1-hexyloxy-N,N-dimethyl formic acid amide, 1-cyclohexyloxy-N,N-dimethyl formic acid amide, 1-methoxy-N,N-diethyl formic acid amide, 1-ethoxy-N,N-diethyl formic acid amide, 1-n-propoxy-N,N-diethyl formic acid amide, 1-isopropoxy-N,N-diethyl formic acid amide, 1-n-butoxy-N,N-diethyl formic acid amide, 1-sec-butoxy-N,N-diethyl formic acid amide, 1-pentyloxy-N,N-diethyl formic acid amide, 1-cyclopentyloxy-N,N-diethyl formic acid amide, 1-hexyloxy-N,N-diethyl formic acid amide, 1-cyclohexyloxy-N,N-diethyl formic acid amide, 1-methoxy-N,N-dipropyl formic acid amide, 1-ethoxy-N,N-dipropyl formic acid amide, 1-n-propoxy-N,N-dipropyl formic acid amide, 1-isopropoxy-N,N-dipropyl formic acid amide, 1-n-butoxy-N,N-dipropyl formic acid amide, 1-sec-butoxy-N,N-dipropyl formic acid amide, 1-pentyloxy-N,N-dipropyl formic acid amide, 1-cyclopentyloxy-N,N-dipropyl formic acid amide, 1-hexyloxy-N,N-dipropyl formic acid amide and 1-cyclohexyloxy-N,N-dipropyl formic acid amide.

Among these, the amide-based solvent (B) is preferably 3-methoxy-N,N-dimethylpropionamide or 3-n-butoxy-N,N-dimethylpropionamide.

Specific examples of commercial items of the amide solvent include Equamide (trade name) made by Idemitsu Kosan Co., Ltd.

The amide-based solvent (B) may be used alone or in combination of two or more kinds.

The ink of the invention contains the amide-based solvent (B), preferably, in the range of 1 to 100% by weight, further preferably, in the range of 20 to 80% by weight, still further preferably, in the range of 30 to 70% by weight, based on 100% by weight of the total of the amide-based solvent (B) and solvent (B') described below. If the content of the amide-based solvent (B) is within the range described above, an ink having a good storage stability, jettability, and patternability is composed, and the ink hardly causing degradation of the inkjet head, and so forth is obtained.

### 1.2-2. Solvent (B')

The solvent (B') is a solvent other than the amide-based solvent (B), and is not particularly limited, if the solvent is a compound that can dissolve the component (A) when mixed with amide-based solvent (B).

The solvent (B') preferably has a boiling point in the range of 150 to 300°C, further preferably, in the range of 150 to 270°C.

Specific examples of the solvent (B') include ethanol, ethylene glycol, propylene glycol, glycerin, ethylene glycol monomethyl ether, ethylene glycol monobutyl ether, ethylene glycol monophenyl ether, ethylene glycol dimethyl ether, ethylene glycol monomethyl ether acetate, ethylene glycol monoethyl ether acetate, diethylene glycol monomethyl ether, diethylene glycol monobutyl ether, diethylene glycol dimethyl ether, diethylene glycol diethyl ether, diethylene glycol dibutyl ether, diethylene glycol ethylmethyl ether (abbreviation: EDM), diethylene glycol isopropylmethyl ether, diethylene glycol butyl methyl ether, diethylene glycol monoethyl ether acetate, triethylene glycol monomethyl ether, triethylene glycol dimethyl ether, triethylene glycol divinyl ether, propylene glycol monomethyl ether (1-methoxy-2-propanol), propylene glycol monoethyl ether (1-ethoxy-2-propanol), propylene glycol monobutyl ether (1-butoxy-2-propanol), propylene glycol dimethyl ether, propylene glycol monomethyl ether acetate, dipropylene glycol monomethyl ether, dipropylene glycol dimethyl ether, tripropylene glycol monomethyl ether, tripropylene glycol dimethyl ether, tetramethylene glycol monovinyl ether, methyl 3-methoxypropionate, ethyl 3-ethoxypropionate, ethyl lactate, methyl benzoate, ethyl benzoate, anisole, cyclohexanone, Y-butyrolactone (abbreviation: GBL), 1,3-dioxolane, 1,4-dioxane, 2-pyrrolidone, 1-methyl-2-pyrrolidone (abbreviation: NMP), 1-ethyl-2-pyrrolidone, 1-butyl-2-pyrrolidone, 1-vinyl-2-pyrrolidone, 1-(2-hydroxyethyl)-2-pyrrolidone, 1-acetyl-2-pyrrolidone, N-methyl-ε-caprolactam, N,N-dimethylacetamide, N,N-diethylacetamide, N,N-dimethylpropionamide and 1,3-dimethyl-2-imidazolidinone.

Among these, the solvent (B') is preferably ethyl lactate, ethylene glycol monobutyl ether, diethylene glycol monoethyl ether acetate, diethylene glycol dimethyl ether, diethylene glycol ethylmethyl ether, propylene glycol monomethyl ether acetate, methyl 3-methoxypropionate or γ-butyrolactone in view of hardly causing degradation of the inkjet head.

The solvent (B') may be used alone or in combination of two or more kinds.

The ink of the invention contains the solvent (B') in the range of 0 to 99% by weight, further preferably, in the range of 20 to 80% by weight, still further preferably, in the range of 30 to 70% by weight, based on 100% by weight of the total of the amide-based solvent (B) and the solvent (B'). If the content of solvent (B') is within the range described above, an ink having a suitable viscosity and a good jettability is obtained.

### 1.3. Additive

The ink of the invention may contain an additive other than component (A), amide-based solvent (B) and solvent (B') within the range in which advantageous effects of the invention are not adversely affected, depending on objective characteristics. Specific examples of such an additive include a high molecular compound, an epoxy compound, an acrylic resin, a surfactant, an antistatic agent, a coupling agent, an epoxy curing agent, a pH adjuster, an anti-rust agent, a preservative, an antifungal agent, an antioxidant, a reduction inhibitor, an evaporation accelerator, a chelating agent, a water-soluble polymer, a pigment, titanium black, carbon black and a dye.

### 1.3-1. High molecular compound

The high molecular compound is not particularly limited. Specific examples include polyamide acid (excluding amide acid derivative (A1)), soluble polyimide (excluding imidized substance (A2)), polyamide, polyamideimide, polyamide acid ester, polyester, an acrylic acid polymer, an acrylate polymer, polyvinyl alcohol, and polyoxyethylene. The high molecular compound may be used alone or in combination of two or more kinds.

As the high molecular compound, a high molecular compound having a weight average molecular weight in the range of 1,000 to 200, 000 is preferably used in view of an excellent solubility in the amide-based solvent (B), and so forth. The weight average molecular weight of the high molecular compound is preferably in the range of 1,000 to 180,000, further preferably, in the range of 1,000 to 160,000, particularly preferably, in the range of 1,000 to 150,000 from a viewpoint of the solubility of the high molecular compound in amide-based solvent (B).

If a high molecular compound having a weight average molecular weight of 1,000 or more is used, the high molecular compound is not evaporated by heat treatment upon forming the polyimide film, and thus a chemically and mechanically stable polyimide film is obtained. Moreover, because a high molecular compound having a weight average molecular weight of 200,000 or less has a particularly high solubility in amide-based solvent (B), the concentration of the high molecular compound in the ink of the invention can be increased. Therefore, flexibility and heat resistance of the polyimide film obtained from the ink can be improved.

The weight average molecular weight of the high molecular compound can be measured according to a gel permeation chromatography (GPC) method.

For example, the high molecular compound is mixed with N,N-dimethylformamide (DMF)to prepare a solution having a concentration of about 1% by weight of the high molecular compound. Then, the weight average molecular weight can be determined by the GPC method by using the solution, using columns prepared by combining G4000HXL, G3000HXL, G2500HXL, and G2000HXL made by Tosoh Corporation in series in the order as a column, under conditions of a column temperature of 40 °C and a flow rate of 1.0 ml/min, and using DMF as a developer, and then calculating a polystyrene-equivalent weight average molecular weight.

The concentration of the high molecular compound in the ink of the invention is ordinarily in the range of 0 to 20% by weight, preferably, in the range of 0 to 10% by weight. If the high molecular compound is within such a concentration range, a polyimide film having good characteristics as an insulating film tends to be obtained.

### 1.3-2. Epoxy compound

The epoxy compound is not particularly limited, if the epoxy compound is a compound having an oxirane or oxetane. The epoxy compound is preferably a compound having two or more oxiranes.

Specific examples of the epoxy compound include a bisphenol A epoxy compound, a glycidyl ester-type epoxy compound, an alicyclic epoxy compound, a polymer of a monomer having an oxirane, and a copolymer of the monomer having the oxirane with any other monomer.

Specific examples of the monomer having the oxirane include glycidyl (meth)acrylate, 3,4-epoxycyclohexyl (meth)acrylate and methylglycidyl (meth)acrylate.

Specific examples of any other monomer to be copolymerized with the monomer having the oxirane include (meth) acrylic acid, methyl (meth)acrylate, ethyl (meth)acrylate, isopropyl (meth)acrylate, n-butyl (meth)acrylate, iso-butyl (meth)acrylate, tert-butyl (meth)acrylate, cyclohexyl (meth)acrylate, benzyl (meth)acrylate, 2-hydroxyethyl (meth)acrylate, 2-hydroxypropyl (meth)acrylate, styrene, methylstyrene, chloromethylstyrene, (3-ethyl-3-oxetanyl)methyl (meth)acrylate, N-cyclohexylmaleimide and N-phenylmaleimide.

Preferred specific examples of the polymer of the monomer having the oxirane, and the copolymer of the monomer having the oxirane with any other monomer include polyglycidyl methacrylate, a methyl methacrylate-glycidyl methacrylate copolymer, a benzyl methacrylate-glycidyl methacrylate copolymer, a n-butyl methacrylate-glycidyl methacrylate copolymer, a 2-hydroxyethyl methacrylate-glycidyl methacrylate copolymer, a (3-ethyl-3-oxetanyl)methyl methacrylate-glycidyl methacrylate copolymer and a styrene-glycidyl methacrylate copolymer. When the ink of the invention contains the epoxy compounds, a polyimide film having an excellent heat resistance is obtained, and therefore containing such epoxy compounds is preferred.

Specific examples of the epoxy compounds include "jER 807", "jER 815", "jER 825", "jER 827", "jER 828", "jER 190P", "jER 191P", "jER 1004" and "jER 1256" (trade names) (Mitsubishi Chemical Corporation), "Araldite CY177" and "Araldite CY184" (trade names) (Huntsman Japan KK), "Celloxide 2021P", "Celloxide 3000" and "EHPE-3150" (trade names) (Daicel Chemical Industries, Ltd.), "Techmore VG3101L" (trade name) (Mitsui Chemicals, Inc.), N,N,N',N'-tetraglycidyl-m-xylenediamine, 1,3-bis(N,N-diglycidylaminomethyl)cyclohexane and N,N,N',N'-tetraglycidyl-4,4'-diaminodiphenylmethane. Among these epoxy compounds, when Araldite CY184, Celloxide 2021P, Techmore VG3101L or jER 828 is used, a polyimide film having a particularly good flatness is obtained, and therefore use of such an epoxy compound is preferred.

Specific examples of the epoxy compounds further include compounds represented by formula (I) to formula (VI) described below. Among these epoxy compounds, the compounds represented by formulas (I), (V) and (VI) described below are preferred because a polyimide film having a particularly good flatness is obtained.

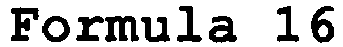

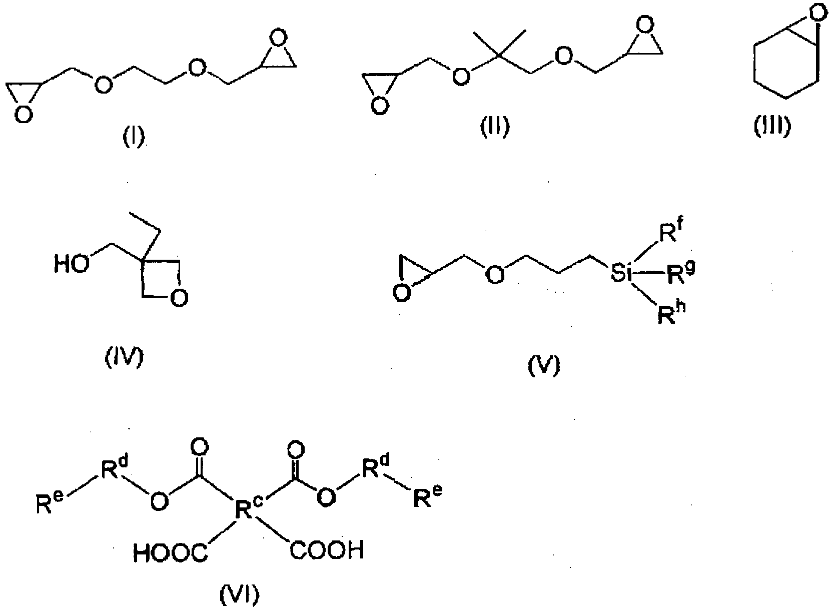

In the formula (V), R^{f}, R^{g} and R^{h} are each independently hydrogen or an organic group having 1 to 30 carbon atoms. Specific examples of the organic group having 1 to 30 carbon atoms include a hydrocarbon group having 1 to 30 carbon atoms.

In the formula (VI), R^{c} is an organic group having 2 to 100 carbon atoms. Specific examples of the organic group having 2 to 100 carbon atoms include a hydrocarbon group having 2 to 100 carbon atoms.

In the formula (VI), R^{d} is independently an organic group having 1 to 30 carbon atoms. Specific examples of the organic group having 1 to 30 carbon atoms include a straight-chain or branched-chain hydrocarbon group having 1 to 30 carbon atoms, preferably, a hydrocarbon group that may include a ring structure or oxygen. Specific examples of the ring structure include phenyl, cyclohexyl, naphthyl, cyclohexenyl and tricyclo[5.2.1.0^{2,6}]decanyl.

In the formula (VI), R^{e} is independently an organic group having an oxetane, oxirane or 1,2-epoxycyclohexane, preferably, an organic group selected from the group of formula (VII) to formula (IX) described below.

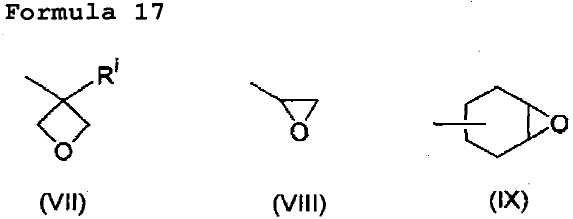

In the formula (VII), Rⁱ is hydrogen or alkyl having 1 to 3 carbon atoms.

Preferred examples of the compounds represented by the formula (VI) include compounds represented by formula (X) described below.

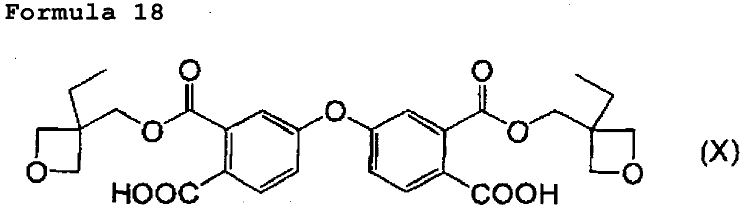

The epoxy compound may be used alone or in combination of two or more kinds.

When the epoxy compound is contained in the ink of the invention, the concentration of the epoxy compound in the ink is not particularly limited, but is preferably in the range of 0.1 to 20% by weight, further preferably, in the range of 1 to 10% by weight. When the concentration is within the range described above, heat resistance, chemical resistance and flatness of the resultant polyimide film become good.

### 1.3-3. Acrylic resin

The acrylic resin is not particularly limited, if the acrylic resin is a resin having an acryloyl group or a methacryloyl group. Specific examples include a homopolymer of a monomer such as polymerizable monofunctional (meth)acrylate having a hydroxyl group; polymerizable monofunctional (meth)acrylate having no hydroxyl group; bifunctional (meth)acrylate; trifunctional or higher functional (meth) acrylate; monofunctional (meth) acrylate including an oxetane or epoxy (oxirane) within a molecule; multifunctional (meth)acrylate including an oxetane or epoxy (oxirane) within a molecule, and a copolymer prepared from the monomers.

"(Meth)acrylate" herein indicates both or either one of acrylate and methacrylate.

A compound having one polymerizable group is expressed as a monofunctional compound, and a compound having two polymerizable groups is expressed as a bifunctional compound. "Trifunctional" or "multifunctional" is expressed based on the number of polymerizable groups.

Specific examples of the polymerizable monofunctional monomer having a hydroxyl group include 2-hydroxyethyl (meth)acrylate, 2-hydroxypropyl (meth)acrylate, 4-hydroxybutyl (meth)acrylate, glycerol mono(meth)acrylate and 1, 4-cyclohexanedimethanol mono (meth) acrylate. Among these, the monomer is preferably 4-hydroxy butylacrylate and 1,4-cyclohexane dimethanol monoacrylate in view of allowing flexibility of the polyimide film to be formed.

Specific examples of the polymerizable monomer having no hydroxyl group include methyl (meth)acrylate, ethyl (meth)acrylate, isopropyl (meth)acrylate, butyl (meth)acrylate, iso-butyl (meth)acrylate, tert-butyl (meth)acrylate, cyclohexyl (meth) acrylate, isobornyl (meth) acrylate, phenyl (meth)acrylate, benzyl (meth)acrylate, tricyclo[5.2.1.0^{2,6}]decanyl (meth)acrylate, dicyclopentenyloxyethyl (meth)acrylate, 5-tetrahydrofurfuryl oxycarbonylpentyl (meth)acrylate, (meth)acrylate of ethylene oxide adduct of lauryl alcohol, ω-carboxypolycaprolactone mono(meth)acrylate, 3-methyl-3-(meth)acryloxy methyloxetane, styrene, methylstyrene, chloromethylstyrene, vinyltoluene, N-acryloyl morpholine, N-cyclohexylmaleimide, N-phenylmaleimide, (meth)acrylamide, polystyrene macromonomer, polymethyl methacrylate macromonomer, (meth)acrylic acid, crotonic acid, α-chloroacrylic acid, cinnamic acid, maleic acid, fumaric acid, itaconic acid, citraconic acid, mesaconic acid, succinic acid mono[2-(meth)acryloyloxyethyl] ester, maleic acid mono[2-(meth)acryloyloxyethyl] ester and cyclohexene 3,4-dicarboxylic acid mono[2-(meth)acryloyloxyethyl] ester.

Specific examples of the monofunctional (meth)acrylate including a oxetane or epoxy (oxirane) in a molecule or the multifunctional (meth)acrylate including a oxetane or epoxy (oxirane) within a molecule include glycidyl (meth)acrylate, methylglycidyl (meth)acrylate, 3,4-epoxycyclohexyl (meth)acrylate, (3-ethyl-3-oxetanyl)methyl (meth)acrylate, 3-ethyl-3-(meth)acryloxymethyl oxetane, 3-methyl-3-(meth)acryloxyethyl oxetane, 3-ethyl-3-(meth)acryloxyethyl oxetane, 2-phenyl-3-(meth)acryloxymethyl oxetane, 2-trifluoromethyl-3-(meth)acryloxymethyl oxetane, 4-trifluoro methyl-2-(meth)acryloxymethyl oxetane and p-vinylphenyl-3-ethyloxeta-3-yl methyl ether.

Specific examples of the bifunctional (meth) acrylate include bisphenol-F ethylene oxide-modified di(meth)acrylate, bisphenol-A ethylene oxide-modified di(meth)acrylate, isocyanuric acid ethylene oxide-modified di(meth)acrylate, polyethylene glycol di(meth)acrylate, polypropylene glycol di(meth)acrylate, pentaerythritol di(meth)acrylate, pentaerythritol di(meth)acrylate monostearate, dipentaerythritol di(meth)acrylate, 1,4-butanediol di(meth)acrylate, 1,6-hexanediol di(meth)acrylate, 1,9-nonanediol di(meth)acrylate, 1,4-cyclohexane dimethanol di(meth)acrylate, 2-n-butyl-2-ethyl-1,3-propanediol di(meth)acrylate and trimethylolpropane di(meth)acrylate.

Specific examples of the trifunctional or higher functional (meth)acrylate include trimethylolpropane tri(meth)acrylate, ethylene oxide-modified trimethylolpropane tri(meth)acrylate, propylene oxide-modified trimethylolpropane tri(meth)acrylate, epichlorohydrin-modified trimethylolpropane tri(meth)acrylate, ditrimethylolpropane tetra(meth)acrylate, glycerol tri(meth)acrylate, epichlorohydrin-modified glycerol tri(meth)acrylate, diglycerol tetra(meth)acrylate, pentaerythritol tri(meth)acrylate, pentaerythritol tetra(meth)acrylate, dipentaerythritol penta(meth)acrylate, alkyl-modified dipentaerythritol penta(meth)acrylate, alkyl-modified dipentaerythritol tetra(meth)acrylate, alkyl-modified dipentaerythritol tri(meth)acrylate, dipentaerythritol hexa(meth)acrylate, caprolactone-modified dipentaerythritol hexa(meth)acrylate, ethylene oxide-modified phosphoric acid tri(meth)acrylate, tris[(meth)acryloxyethyl]isocyanurate, caprolactone-modified tris[(meth)acryloxyethyl]isocyanurate and urethane (meth)acrylate.

The acrylic resin may be used alone or in combination of two or more kinds.

When the acrylic resin is contained in the ink of the invention, the concentration of the acrylic resin in the ink is not particularly limited, but is preferably in the range of 0.1 to 20% by weight, further preferably, in the range of 1 to 10% by weight. When the concentration is within the range described above, a polyimide film having an excellent heat resistance, chemical resistance and flatness is obtained.

### 1.3-4. Surfactant

The surfactant can be used in order to improve wettability, levelability or jettability of the ink of the invention relative to a coating object (support, for example).

In view of allowing improvement of jettability of the ink of the invention, specific examples of the surfactant include a silicone surfactant such as "BYK-300", "BYK-306", "BYK-335", "BYK-310", "BYK-341", "BYK-344" and "BYK-370" (trade names) (BYK-Chemie GmbH); an acrylic surfactant such as "BYK-354", "BYK-358" and "BYK-361" (trade names) (BYK-Chemie GmbH); and a fluorochemical surfactant such as "DFX-18", "Futargent 250" and "Futargent 251" (trade names) (Neos Co., Ltd.).

The surfactant may be used alone or in combination of two or more kinds.

When the surfactant is contained in the ink of the invention, the concentration of the surfactant in the ink is preferably in the range of 0.01 to 1% by weight.

### 1.3-5. Antistatic agent

The antistatic agent is used in order to prevent the ink of the invention from being charged. The antistatic agent is not particularly limited, and a publicly known antistatic agent can be used. Specific examples include a metal oxide such as tin oxide, tin oxide-antimony oxide composite oxide and tin oxide-indium oxide composite oxide, and a quaternary ammonium salt.

The antistatic agent may be used alone or in combination of two or more kinds.

When the antistatic agent is contained in the ink of the invention, the concentration of the antistatic agent in the ink is preferably in the range of 0.01 to 1% by weight.

### 1.3-6. Coupling agent

The coupling agent is not particularly limited, and a publicly known coupling agent can be used. A silane coupling agent is preferably used. Specific examples of the silane coupling agent include a trialkoxysilane compound and a dialkoxysilane compound.

Specific examples of the trialkoxysilane compound or the dialkoxysilane compound include γ-vinylpropyl trimethoxysilane, γ-vinylpropyl triethoxysilane, γ-acryloylpropylmethyl dimethoxysilane, γ-acryloylpropyl trimethoxysilane, γ-acryloylpropylmethyl diethoxysilane, γ-acryloylpropyl triethoxysilane, γ-methacryloylpropylmethyl dimethoxysilane, γ-methacryloylpropyl trimethoxysilane, γ-methacryloylpropylmethyl diethoxysilane, γ-methacryloylpropyl triethoxysilane, γ-glycidoxypropylmethyl dimethoxysilane, γ-glycidoxypropyl trimetoxysilane, γ-glycidoxypropylmethyl dietoxysilane, γ-glycidoxypropyl triethoxysilane, γ-aminopropylmethyl dimethoxysilane, γ-aminopropyl trimethoxysilane, γ-aminopropylmethyl diethoxysilane, γ-aminopropyl triethoxysilane, N-aminoethyl-γ-iminopropylmethyl dimethoxysilane, N-aminoethyl-γ-aminopropyl trimethoxysilane, N-aminoethyl-γ-aminopropyl triethoxysilane, N-phenyl-γ-aminopropyl trimethoxysilane, N-phenyl-γ-aminopropyl triethoxysilane, N-phenyl-γ-aminopropylmethyl dimethoxysilane, N-phenyl-γ-aminopropylmethyl diethoxysilane, γ-mercaptopropylmethyl dimethoxysilane, γ-mercaptopropylmethyl diethoxysilane, γ-mercaptopropyl trimethoxysilane, γ-mercaptopropyl triethoxysilane, γ-isocyanatopropylmethyl diethoxysilane and Υ-isocyanatopropyl triethoxysilane.

Among these, the trialkoxysilane compound or the dialkoxysilane compound is particularly preferably γ-vinylpropyl trimethoxysilane, γ-acryloylpropyl trimethoxysilane, γ-methacryloylpropyl trimethoxysilane and γ-isocyanatopropyl triethoxysilane.

The coupling agent may be used alone or in combination of two or more kinds.

When the coupling agent is contained in the ink of the invention, the concentration of the coupling agent in the ink is preferably in the range of 0.01 to 3% by weight.

### 1.3-7. Epoxy curing agent

The epoxy curing agent is not particularly limited, and a publicly known epoxy curing agent can be used. Specifically, such a curing agent can be used as an organic acid dihydrazide compound, imidazole and a derivative thereof, dicyandiamides, aromatic amine, polycarboxylic acid and polycarboxylic anhydride.

The polycarboxylic acid means a compound having two or more carboxyl groups in one molecule.

Further specific examples of the epoxy curing agent include dicyandiamides such as dicyandiamide; an organic acid dihydrazide compound such as adipic acid dihydrazide and 1,3-bis(hydrazinocarboethyl-5-isopropylhydantoin; an imidazole derivative such as 2,4-diamino-6-[2'-ethylimidazolyl(1')]-ethyltriazine, 2-phenylimidazole, 2-phenyl-4-methylimidazole and 2-phenyl-4-methyl-5-hydroxymethylimidazole; polycarboxylic anhydride such as phthalic anhydride, trimellitic anhydride and 1,2,4-cyclohexanetricarboxylic acid-1,2-anhydride; and polycarboxylic acid such as trimellitic acid. Preferred examples include trimellitic acid and 1,2,4-cyclohexanetricarboxylic acid-1,2-anhydride.

The epoxy curing agent may be used alone or in combination of two or more kinds.

When the epoxy curing agent is contained in the ink of the invention, the concentration of the epoxy curing agent in the ink is preferably in the range of 0.2 to 5% by weight.

### 1.4. Viscosity of the ink

The viscosity of the ink of the invention at a temperature when the ink is jetted from the inkjet coater (jetting temperature) is preferably in the range of 1 to 50 mPa·s, further preferably, in the range of 5 to 20 mPa·s, still further preferably, in the range of 8 to 15 mPa·s. When the viscosity is within the range described above, an ink having an excellent jetting accuracy is obtained. When the viscosity is lower than 15 mPa·s, a poor jetting hardly occurs, and therefore the range is preferred.

Moreover, the viscosity of the ink after storage, for example, for 7 days is also preferably within the range described above. A change of the viscosity between an ink at preparation and an ink after being allowed to stand for 7 days is preferably within the range of 15% or less. If the change exceeds 15%, a change of jetting conditions is needed in many cases, and jetting may become quite difficult.

The viscosity of the ink can be adjusted by appropriately selecting types of solvents and usage thereof depending on component (A) to be used.

Moreover, the ink is jetted at a normal temperature (25°C) in many cases. Therefore, the viscosity of the ink at 25°C is also preferably in the range similar to the preferred range at the jetting temperature.

### 1.5. Surface tension of the ink

The surface tension of the ink of the invention is preferably in the range of 20 to 70 mN/m, further preferably, in the range of 20 to 40 mN/m. If the surface tension is within the range described above, a liquid drop having a desired size and shape can be easily formed upon jetting the ink, and an ink having a good jettability is obtained, and therefore the range is preferred.

The surface tension of the ink can be adjusted by appropriately selecting the types or the amount of solvents to be used depending on component (A) to be used, or by using the surfactant if necessary.

### 2. Polyimide film

The polyimide film of the invention is formed from the ink of the invention.

The polyimide film has an excellent heat resistance and electric insulation, and thus can improve reliability and yield of an electronic component.

### 2.1. Method for forming the polyimide film

The polyimide film can be preferably formed on a whole support surface according to a method including a process for coating the ink of the invention on the support to form a coating film according to an inkjet method (hereinafter, referred to also as "coating film formation process") and a process for curing the coating film (hereinafter, referred to also as "curing process") . A predetermined patterned (lined, for example) polyimide film can also be formed in a similar manner. When the ink of the invention is jetted in a patterned form, a patterned polyimide film can be formed. Unless otherwise noted herein, the polyimide film should include the patterned polyimide film.

### 2.1-1. Coating film formation process

The coat**ing film** formation process can be performed according to the inkjet method by means of the inkjet coater.

Specific examples of the jetting method according to the inkjet method include piezoelectric type, bubble jet type (registered trademark), continuous flow type and electrostatic induction type jetting methods, preferably, the piezoelectric jetting method.

The ink of the invention can be jetted according to various methods, and can be coated in a predetermined patterned form by suitably selecting each component contained.

The inkjet coater is not limited to an inkjet coater having a constitution in which the inkjet head and an ink storage part are separate but may also have a constitution in which the inkjet head and the ink storage part are undetachably integrated. Moreover, the ink storage part may be detachably or undetachably integrated to the inkjet head and mounted to a carriage, or provided on a fixed member of the coater. In the latter case, the ink storage part may have a form for supplying the ink to a coating head through an ink supply member, for example, a tube.

When a constitution for allowing a preferred negative pressure to act onto the inkjet head is provided for an ink tank, the inkjet coater can adopt a form prepared by arranging an absorber for the ink storage part of the ink tank, or a form having a flexible ink storage bag and a spring part for allowing force in a direction for expanding an internal volume to act to the bag, or the like.

The coater may be a serial printer, or a line printer composed by aligning coating elements over the range corresponding to an overall width of a coating medium.

The jetting temperature upon jetting the ink of the invention may be appropriately adjusted depending on the viscosity of the ink to be used, and is preferably in the range of 10 to 50°C, further preferably, in the range of 15 to 40°C.

Specific examples of the support include a glass epoxy support, a glass composite support, a paper phenol support, a paper epoxy support, a green epoxy support, and BT resin support in conformity with various standards such as FR-1, FR-3, FR-4, CEM-3 or E668.

Furthermore, the specific examples include a support including a metal such as copper, brass, phosphor bronze, copper-beryllium alloy, aluminum, gold, silver, nickel, tin, chromium or stainless steel (a support may have a layer including the metals on a surface); a support including an inorganic substance such as aluminum oxide (alumina), aluminum nitride, zirconium oxide (zirconia), silicate of zirconium (zircon), magnesium oxide (magnesia), aluminum titanate, barium titanate, lead titanate (PT), lead zirconate titanate (PZT), lead lanthanum zirconium titanate (PLZT), lithium niobate, lithium tantalate, cadmium sulfide, molybdenum sulfide, beryllium oxide (beryllia), silicon oxide (silica), silicon carbide, silicon nitride, boron nitride, zinc oxide, mullite, ferrite, steatite, forsterite, spinel or spodumene (a support may have a layer including the inorganic substances on the surface) ; a support including a resin such as polyethylene terephthalate (PET) resin, polybutylene terephthalate (PBT) resin, polycyclohexylene dimethylene terephthalate (PCT) resin, polyphenylene sulfide (PPS) resin, polycarbonate resin, polyacetal resin, polyphenylene ether resin, polyimide resin, polyamide resin, polyarylate resin, polysulfone resin, polyether sulfone resin, polyether imide resin, polyamide imide resin, epoxy resin, acrylic resin, Teflon (registered trademark), thermoplastic elastomer or liquid crystal polymer (a support may have a layer including the resins on the surface); a semiconductor support including silicon, germanium or gallium arsenide (silicon wafer); a glass support; a support prepared by forming an electrode material (wiring) such as tin oxide, zinc oxide, indium tin oxide (ITO) or antimony tin oxide (ATO) on the surface; and a gel sheet such as αGEL, βGEL, θGEL or γGEL (registered trademarks of Taica Corporation, for all types of GEL).

The polyimide film is preferably formed on the support including the polyimide resin described above, particularly, a film-shaped support including the polyimide resin, or on the silicon wafer.

The coating film formation process preferably includes a process for coating the ink of the invention on the support according to the inkjet method, and then heating an ink-coated support using a hot plate, an oven or the like, and thus removing the solvent in the ink by vaporizing the solvent, and then drying the coat. The heating conditions are different depending on types and ratios of each component contained in the ink. The conditions are ordinarily at a temperature in the range of 70 to 150°C for 5 to 15 minutes when using the oven, or 1 to 5 minutes when using the hot plate.

The thickness of the coating film obtained may be appropriately adjusted depending on a desired application, and is preferably in the range of 1 to 20 µm, further preferably, in the range of 1 to 10 µm.

### 2.1-2. Curing process

In the curing process, the coating film obtained in the coating film formation process is cured.

The curing process may be performed by applying heat treatment to the coating film. When the component (A) consists essentially of imidized substance (A2), the curing process may be performed by irradiating the coating film with ultraviolet light, ion beams, electron beams or gamma-rays without limiting to the heat treatment.

In order to obtain a polyimide film having an excellent heat resistance, chemical resistance and flatness and also a sufficient mechanical strength, the heat treatment is preferably applied at a temperature in the range of 150 to 350°C, further preferably, in the range of 200 to 300°C, for 30 to 90 minutes when using the oven, or 5 to 30 minutes when using the hot plate.

The thickness of the thus obtained polyimide film may be appropriately adjusted depending on a desired application, and is ordinarily in the range of 2 µm or more, preferably, in the range of 2 to 5 µm. The ink of the invention can contain component (A) at a high concentration. Therefore, a polyimide film having a thickness higher than a film obtained from an ink that has been used so far can be easily formed.

Thus, according to the ink of the invention, a thick polyimide film can be obtained by single jetting. Therefore, for example, when a polyimide film having a thickness of about 10 µm is formed, the number of times of repeat coating can be reduced, as compared with an inkjet ink that has been used so far, and a process for manufacturing the polyimide film can be shortened.

The polyimide film of the invention is preferably not peeled from the support depending on an application in some cases. In the case, adhesiveness thereof can be expressed in terms of adhesive strength of the polyimide film to the support. The adhesive strength is preferably 0.2 N/mm or more, further preferably, 0.5 N/mm or more, particularly preferably, in the range of 0.5 to 1.5 N/mm. When the adhesive strength is 0.2 N/mm or more, the polyimide film is not easily peeled from the support, and thus the range is preferred.

### 3. Substrate for an electronic material

A substrate for an electronic material according to the invention has the polyimide film described above. Specific examples of the substrate for an electronic material according to the invention include a film substrate and a semiconductor wafer substrate.

Specific examples of the film substrate described above include a substrate obtained by forming a coating film on a film-shaped support including a film such as a polyimide film on which wiring is preformed according to the inkjet method by coating the ink of the invention on the support, whole surface or in a predetermined patterned form (lined form, for example), according to the inkjet method, and then heating and drying the coating film.

### 4. Electronic component

An electronic component of the invention has the substrate described above.

### Examples

In the following, the invention will be explained by way of Examples and Comparative Examples, but the invention is in no way limited to the Examples.

Names of a reaction raw material and a solvent to be used in Examples and Comparative Examples are expressed using abbreviations. The abbreviations are used for descriptions below.

### Tetracarboxylic anhydride

ODPA: 3,3',4,4'-diphenyl ether tetracarboxylic dianhydride

### Diamine

BAPP: 2,2-bis[4-(4-aminophenoxy)phenyl]propane

### Dicarboxylic anhydride

MA: maleic anhydride
TESA: triethoxysilylpropyl succinic anhydride

### Solvent

EDM: diethylene glycol ethylmethyl ether
NMP: 1-methyl-2-pyrrolidone
GBL: γ-butyrolactone
DMMP: 3-methoxy-N,N-dimethylpropionamide

### Example 1

Into a 100 mL reaction vessel, a stirrer was put, and raw materials were charged as described below, and then stirring was carried out at room temperature for 6 hours, and thus a light yellow solution containing 25% by weight of polyamide acid (hereinafter, referred to also as "ink A") was obtained.
ODPA: 0.712 g
BAPP: 5.66 g
MA: 1.12 g
EDM: 13.5 g
DMMP: 9 g

The weight average molecular weight (Mw) of the polyamide acid obtained was 1, 050. The weight average molecular weight was measured by a gel permeation chromatography (GPC) method. Ink A obtained is mixed with N,N-dimethylformamide (DMF) to prepare a solution having a concentration of about 1% by weight of the polyamide acid. Then, the weight average molecular weight was determined by the GPC method by using the solution, using columns prepared by combining G4000HXL, G3000HXL, G2500HXL, and G2000HXL made by Tosoh Corporation in series in the order as a column, under conditions of a column temperature of 40 °C and a flow rate of 1.0 ml/min, and using DMF as a developer, and then calculating a polystyrene-equivalent weight average molecular weight.

### Example 2

Into a 100 mL reaction vessel, a stirrer was put, and raw materials were charged as described below, and then stirring was carried out at room temperature for 2 hours, and thus a light yellow solution containing 30% by weight of polyamide acid (hereinafter, referred to also as "ink B") was obtained. When measurement was carried out in a manner similar to Example 1 except for using ink B in place of ink A, the weight average molecular weight of the polyamide acid obtained was 1,600.
BAPP: 3.62 g
TESA: 5.37 g
EDM: 10.5 g
DMMP: 10.5 g

### Comparative Example 1

Into a 100 mL reaction vessel, a stirrer was put, and raw materials were charged as described below, and then stirring was carried out at room temperature for 6 hours, and thus a light yellow solution containing 25% by weight of polyamide acid (hereinafter, referred to also as "ink C") was obtained. When measurement was carried out in a manner similar to Example 1 except for using ink C in place of ink A, the weight average molecular weight of the polyamide acid obtained was 1,140.
ODPA: 0.712 g
BAPP: 5.66 g
MA: 1.12 g
EDM: 22.5 g

### Comparative Example 2

Into a 100 mL reaction vessel, a stirrer was put, and raw materials were charged as described below, and then stirring was carried out for 6 hours at room temperature, and thus a light yellow solution containing 25% by weight of polyamide acid (hereinafter, referred to also as "ink D") was obtained. When measurement was carried out in a manner similar to Example 1 except for using ink D in place of ink A, the weight average molecular weight of the polyamide acid obtained was 1,220.
ODPA: 0.712 g
BAPP: 5.66 g
MA: 1.12 g
EDM: 11.25 g
GBL: 11.25 g

### Comparative Example 3

Into a 100 mL reaction vessel, a stirrer was put, and raw materials were charged as described below, and then stirring was carried out at room temperature for 4 hours, and thus a light yellow solution containing 30% by weight of polyamide acid (hereinafter, referred to also as "ink E") was obtained. When measurement was carried out in a manner similar to Example 1 except for using ink E in place of ink A, the weight average molecular weight of the polyamide acid obtained was 1,680.
BAPP: 3.62 g
TESA: 5.37 g
EDM: 10.5 g
GBL: 10.5 g

### (1) Viscosity (storage stability)

Viscosity of ink A to ink E described above was measured at 25°C using an E-type viscometer (VISCONIC EHD, made by TOKYO KEIKI INC.). In addition, viscosity when preparing ink A to ink E, and viscosity after the ink was allowed to stand under room temperature for 7 days from preparation of the ink were measured.

Storage stability of the ink was evaluated from a change of viscosity of ink A to ink E. According the evaluation method, a case where the change of viscosity of the ink after elapse of 7 days is 15% or less was classified as good, and a case where the viscosity changed over 15% was classified as bad.

### (2) Jettability

Pattern coating (line having a length of 5 cm, an interval of 150 µm) was carried out on a glass substrate having a thickness of 0.8 mm using each of ink A to ink E by means of an inkjet coater DMP-2831 made by FUJIFILM Dimatix, Inc. under jetting conditions of a jetting voltage (piezoelectric voltage) of 16 V, a head temperature of 30°C and a driving frequency of 5 kHz. In addition, as for the number of times of coating, coating was applied once when the concentration of polyamide acid in the ink exceeded 25% by weight, and twice when the concentration of polyamide acid in the ink was 25% by weight or less. Moreover, as an inkjet head, a head DMC-11601 (made by FUJIFILM Dimatix, Inc.) in which an amount of a single jetted drop was 1 pL (picoliter) was used.

Upon jetting the ink, a case where the ink is jetted from all 16 nozzles aligned in parallel was classified as good, and a case where the ink is not jetted from at least one nozzle was classified as bad.

An aspect of jetting the ink from the nozzles was observed with a camera built in the inkjet coater.

When ink C was used, jetting the ink from the inkjet coater was not stabilized and a pattern could not be formed.

Furthermore, patternability was evaluated from a shape of the polyimide film as described below.

After the ink was coated, the resultant ink-coated substrate was placed on a hot plate at 80°C, and the ink was dried for 5 minutes. Then, an ink-coated substrate after drying was heated in an oven at 230°C for 30 minutes, and thus a polyimide film in the form of lines was obtained. The line width of the resultant polyimide film was observed by means of an optical microscope.

A case where a patterned polyimide film having a length of 5 cm and an interval of 150 µm was formed was classified as good, and a case where the patterned polyimide film having a length of 5 cm and an interval of 150 µm could not be formed and a case where pattern coating could not be carried out was classified as bad.

**Table 1**

| | Ink | Viscosity at preparation (mPa·s) | Viscosity after 7 days (mPa·s) | Storage stability | Jettability | Shape of polyimide film |
|---|---|---|---|---|---|---|
| Example 1 | A | 11.9 | 13.2 | Good | Good | Good |
| Example 2 | B | 13.6 | 14.0 | Good | Good | Good |
| Comparative Example 1 | C | 9.8 | Not measured | Not measured | Bad | Bad |
| Comparative Example 2 | D | 12.6 | 18.2 | Bad | Not measured | Not measured |
| Comparative Example 3 | E | 13.8 | 31.3 | Bad | Good | Good |

As is clear from the results of the Examples and the Comparative Examples described above, the inkjet ink of the invention has a good jettability and storage stability, and can easily form a desired patterned polyimide film.

### Industrial Applicability

The ink of the invention can be used as an insulating film for a printed-circuit board and an insulating film for a semiconductor device, and also as a material for forming an electronic component, for example.

## Claims

1. An inkjet ink, comprising
a component (A) including at least one kind of compound selected from compound (2) having a constitutional unit represented by formula (2a) described below and having at least one kind of molecular terminal group selected from the group of groups represented by formulas (2b) and (2c) described below, and compounds selected from the group of compounds represented by formula (3) to formula (6) described below, or an imidized substance thereof, and
an amide-based solvent (B) represented by formula (1) described below: 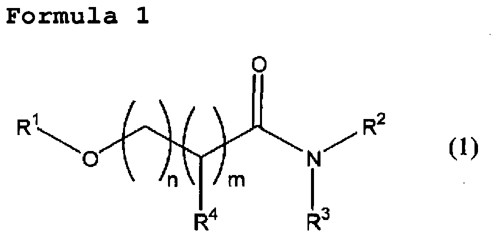 wherein, in the formula (1), R¹ is an organic group having 1 to 18 carbon atoms, R² and R³ satisfy requirement (i) or (ii) described below, R⁴ is hydrogen or methyl, n is an integer from 0 to 3, and m is 0 or 1:
(i) ; R² and R³ are each independently hydrogen or an organic group having 1 to 6 carbon atoms; or
(ii); R² and R³ are bonded with each other to form a ring structure: 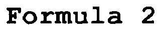 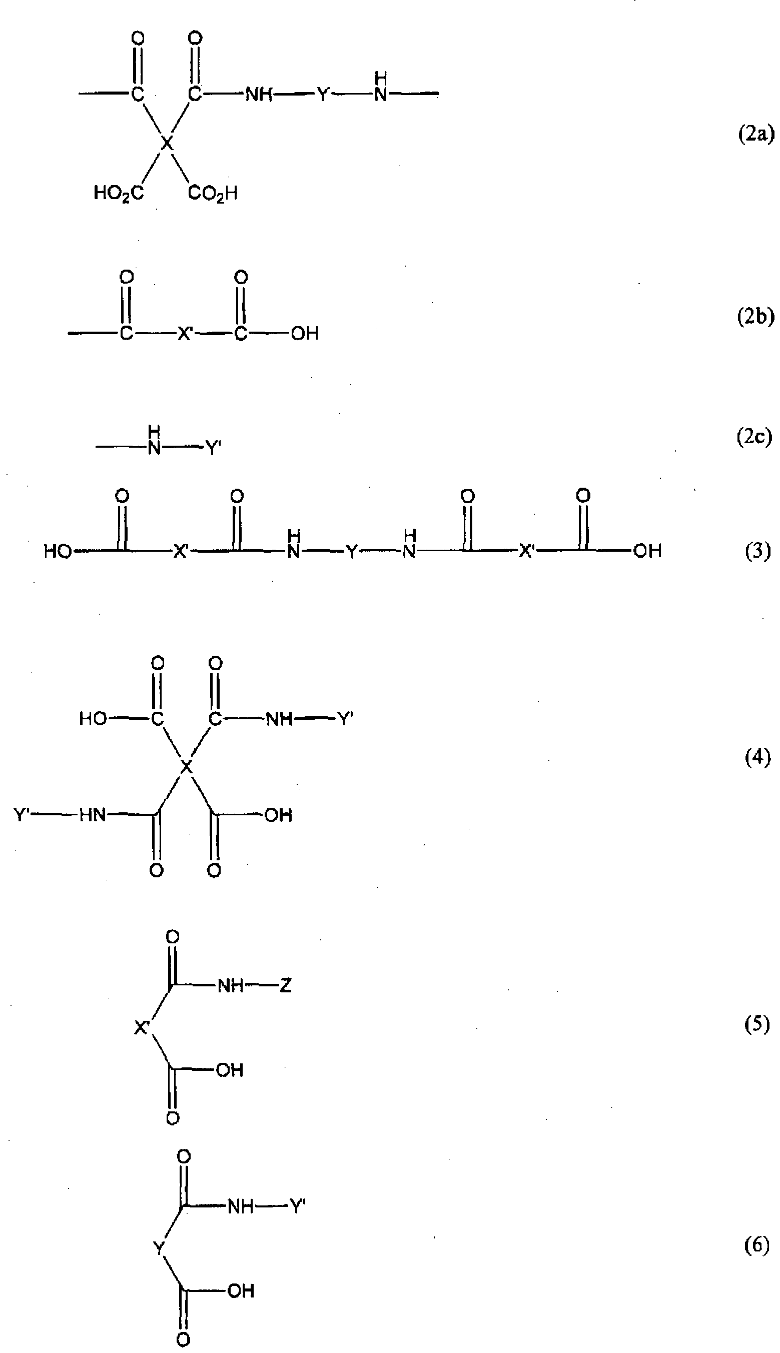
wherein, in the formulas (2a) and (4), X is each independently carbon or an organic group having 2 to 100 carbon atoms,
in the formulas (2a), (3) and (6), Y is each independently an organic group having 1 to 100 carbon atoms,
in the formula (5), Z is an organic group having 1 to 100 carbon atoms, in the formulas (2b), (3) and (5), X' is each independently an organic group having 1 to 100 carbon atoms, and
in the formulas (2c), (4) and (6), Y' is each independently an organic group having 1 to 100 carbon atoms.

2. The inkjet ink according to claim 1, wherein R¹ in the formula (1) is alkyl having 1 to 8 carbon atoms.

3. The inkjet ink according to claim 1 or 2, wherein the compound (2) is at least one kind of compound selected from the group of compounds represented by formula (2-1) to formula (2-3) described below: 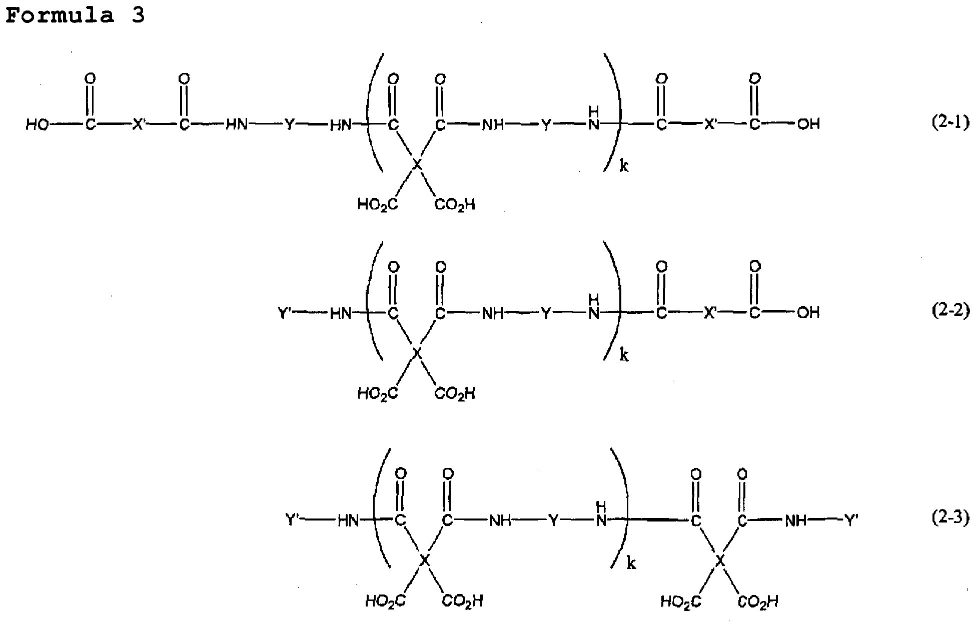 wherein, in the formula (2-1) to formula (2-3), X is each independently defined in a manner identical with X in the formulas (2a) and (4),
in the formula (2-1) to formula (2-3), Y is each independently defined in a manner identical with Y in the formulas (2a), (3) and (6),
in the formulas (2-1) and (2-2), X' is each independently defined in a manner identical with X' in the formulas (2b), (3) and (5), in the formulas (2-2) and (2-3), Y' is each independently defined in a manner identical with Y' in the formulas (2c), (4) and (6), and
in the formula (2-1) to formula (2-3), k is each independently an integer from 1 to 8.

4. The inkjet ink according to any one of claims 1 to 3, wherein X' in the formulas (2b), (3), (5), (2-1) and (2-2) is each independently an organic group having an unsaturated hydrocarbon group and having 2 to 100 carbon atoms or an organic group represented by formula (α) described below, and
Y' in the formulas (2c), (4), (6), (2-2) and (2-3) is each independently an organic group having an unsaturated hydrocarbon group and having 2 to 100 carbon atoms or an organic group represented by formula (β) described below: 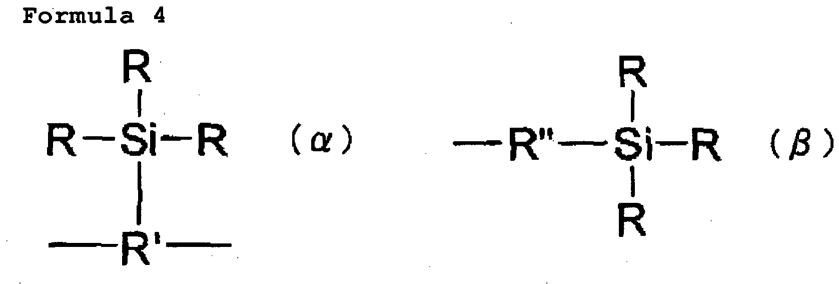 wherein, in the formulas (α) and (β), R is each independently hydrogen, alkyl having 1 to 20 carbon atoms or alkoxy having 1 to 20 carbon atoms, in the formula (α), R' is an organic group having 1 to 20 carbon atoms, and in the formula (β), R" is an organic group having 1 to 20 carbon atoms.

5. The inkjet ink according to any one of claims 1 to 4, further containing solvent (B') other than amide-based solvent (B).

6. The inkjet ink according to any one of claims 1 to 5, wherein the component (A) is contained in an amount of 5 to 95% by weight based on 100% by weight of the inkjet ink.

7. The inkjet ink according to claim 5 or 6, wherein the amide-based solvent (B) is contained in an amount in the range of 1 to 100% by weight based on 100% of the total of the amide-based solvent (B) and the solvent (B').

8. A polyimide film formed using the inkjet ink according to any one of claims 1 to 7.

9. A method for forming a polyimide film, comprising a step for forming a coating film by coating the inkjet ink according to any one of claims 1 to 7 on a support according to an inkjet method, and a step for forming the polyimide film by curing the coating film.

10. A polyimide film formed according to the method for forming the polyimide film according to claim 9.

11. The polyimide film according to claim 8 or 10, wherein the polyimide film is patterned.

12. A substrate for an electronic material, having the polyimide film according to claim 8, 10 or 11.

13. An electronic component, having the substrate for an electronic material according to claim 12.

## Patentansprüche

1. Tintenstrahltinte, die Folgendes umfasst:
eine Komponente (A) mit zumindest einer Art von Verbindung, die aus Verbindung (2) mit einer Grundeinheit, die durch die unten beschriebene Formel (2a) dargestellt ist, und mit zumindest einer Art von molekülendständiger Gruppe, die aus der Gruppe von Gruppen ausgewählt ist, die durch die unten beschriebenen Formeln (2b) und (2c) dargestellt sind, oder eine imidierte Substanz davon und
ein Lösungsmittel auf Amidbasis (B), das durch die unten beschriebene Formel (1) dargestellt ist: 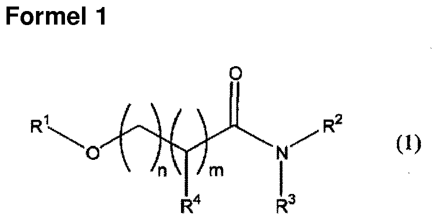
worin R¹ in Formel (1) eine organische Gruppe mit 1 bis 18 Kohlenstoffatomen ist, R² und R³ die nachstehende Anforderung (i) oder (ii) erfüllen, R⁴ Wasserstoff oder Methyl ist, n eine ganze Zahl von 0 bis 3 ist und m = 0 oder 1 ist:
(i): R² und R³ sind jeweils unabhängig Wasserstoff oder eine organische Gruppe mit 1 bis 6 Kohlenstoffatomen; oder
(ii): R² und R³ sind miteinander zu einer Ringstruktur verbunden: 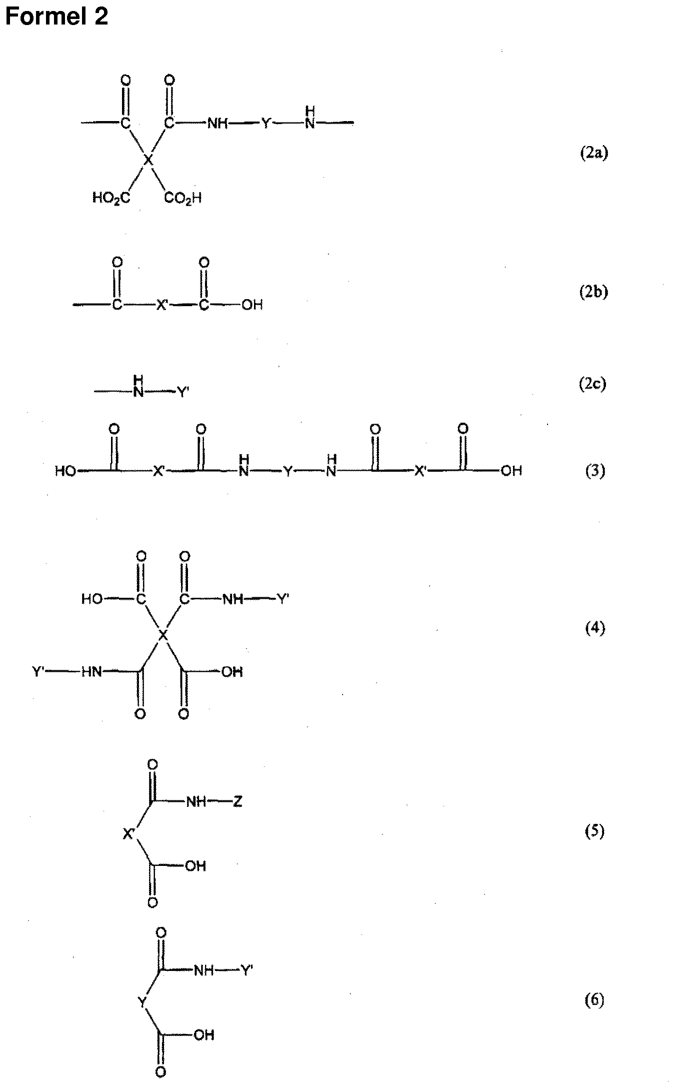
worin X in den Formeln (2a) und (4) jeweils unabhängig Kohlenstoff oder eine organische Gruppe mit 2 bis 100 Kohlenstoffatomen ist,
Y in den Formeln (2a), (3) und (6) jeweils unabhängig eine organische Gruppe mit 1 bis 100 Kohlenstoffatomen ist,
Z in Formel (5) eine organische Gruppe mit 1 bis 100 Kohlenstoffatomen ist,
X' in den Formeln (2b), (3) und (5) jeweils unabhängig eine organische Gruppe mit 1 bis 100 Kohlenstoffatomen ist und
Y' in den Formeln (2c), (4) und (6) jeweils unabhängig eine organische Gruppe mit 1 bis 100 Kohlenstoffatomen ist.

2. Tintenstrahltinte nach Anspruch 1, worin R¹ in Formel (1) Alkyl mit 1 bis 8 Kohlenstoffatomen ist.

3. Tintenstrahltinte nach Anspruch 1 oder 2, worin die Verbindung (2) zumindest eine Art von Verbindung ist, die aus der Gruppe von Verbindungen ausgewählt ist, die durch die nachstehende Formel (2-1) bis Formel (2-3) dargestellt sind: 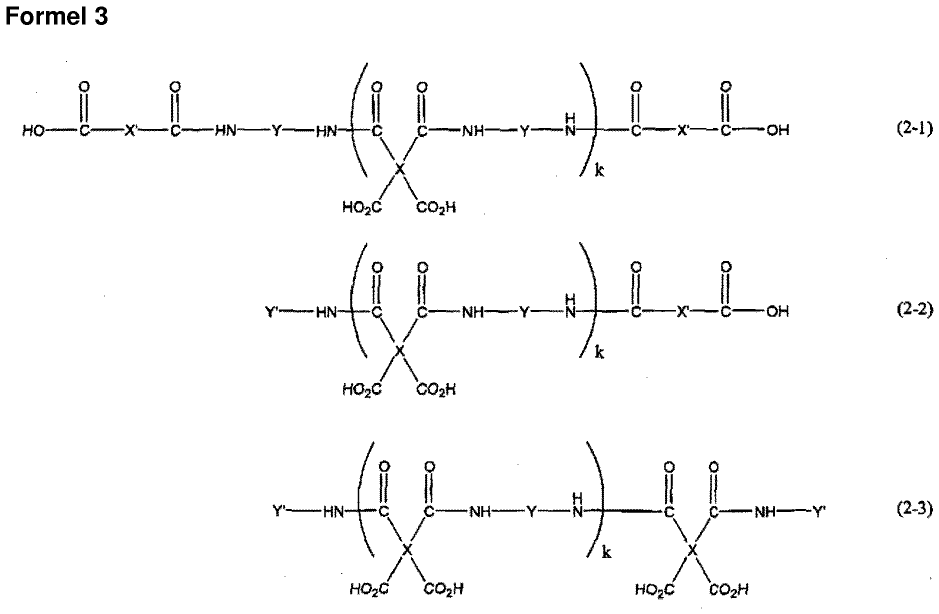 worin X in Formel (2-1) bis Formel (2-3) jeweils unabhängig gleich wie X in den Formeln (2a) und (4) definiert ist,
Y jeweils unabhängig gleich wie Y in den Formeln (2a), (3) und (6) definiert ist,
X' in den Formeln (2-1) und (2-2) jeweils unabhängig gleich wie X' in den Formeln (2b), (3) und (5) definiert ist,
Y' in den Formeln jeweils unabhängig wie Y' in den Formeln (2c), (4) und (6) definiert ist und
k in Formel (2-1) bis Formel (2-3) jeweils unabhängig eine ganze Zahl von 1 bis 8 ist.

4. Tintenstrahltinte nach einem der Ansprüche 1 bis 3, worin X' in den Formeln (2b), (3), (5), (2-1) und (2-2) jeweils unabhängig eine organische Gruppe mit einer ungesättigten Kohlenwasserstoffgruppe und 2 bis 100 Kohlenstoffatomen oder eine organische Gruppe ist, die durch die unten beschriebene Formel (α) dargestellt ist und Y' in den Formeln (2c), (4), (6), (2-2) und (2-3) jeweils unabhängig eine organische Gruppe mit einer ungesättigten Kohlenwasserstoffgruppe und 2 bis 100 Kohlenstoffatomen oder eine organische Gruppe ist, die durch die unten beschriebene Formel (β) dargestellt ist: 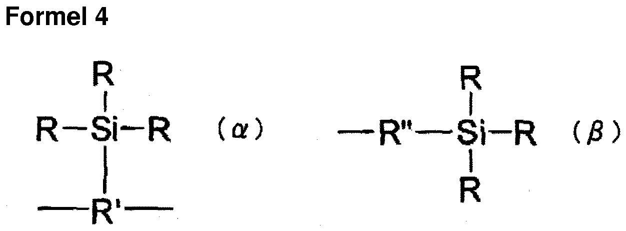 worin R in den Formeln (α) und (β) unabhängig Wasserstoff, Alkyl mit 1 bis 20 Kohlenstoffatomen oder Alkoxy mit 1 bis 20 Kohlenstoffatomen ist, R' in Formel (α) eine organische Gruppe mit 1 bis 20 Kohlenstoffatomen ist und R" eine organische Gruppe mit 1 bis 20 Kohlenstoffatomen ist.

5. Tintenstrahltinte nach einem der Ansprüche 1 bis 4, die weiters Lösungsmittel (B') enthält, das nicht das auf Amid basierende Lösungsmittel (B) ist.

6. Tintenstrahltinte nach einem der Ansprüche 1 bis 5, worin die Komponente (A) in einer Menge von 5 bis 95 Gew.-%, bezogen auf 100 Gew.-% der Tintenstrahltinte, enthalten ist.

7. Tintenstrahltinte nach Anspruch 5 oder 6, worin das auf Amid basierende Lösungsmittel (B) in einer Menge im Bereich von 1 bis 100 Gew.-%, bezogen auf 100 % des gesamten auf Amid basierenden Lösungsmittels (B) und des Lösungsmittels (B'), enthalten ist.

8. Polyimidfilm, der unter Verwendung einer Tintenstrahltinte nach einem der Ansprüche 1 bis 7 gebildet wurde.

9. Verfahren zum Ausbilden eines Polyimidfilms, das einen Schritt des Ausbildens eines Beschichtungsfilms durch Beschichten einer Tintenstrahltinte nach einem der Ansprüche 1 bis 7 auf einem Träger durch ein Tintenstrahlverfahren und einen Schritt des Ausbildens des Polyimidfilms durch Härten des Beschichtungsfilms umfasst.

10. Polyimidfilm, der durch das Verfahren zum Ausbilden des Polyimidfilms nach Anspruch 9 ausgebildet wurde.

11. Polyimidfilm nach Anspruch 8 oder 10, worin der Polyimidfilm strukturiert ist.

12. Substrat für ein elektronisches Material, das einen Polyimidfilm nach Anspruch 8, 10 oder 11 umfasst.

13. Elektronisches Bauteil, das ein Substrat für ein elektronisches Material nach Anspruch 12 umfasst.

## Revendications

1. Encre pour jet d'encre, comprenant
un composant (A) incluant au moins un type de composé sélectionné parmi le composé (2) ayant une unité constitutionnelle représentée par la formule (2a) décrite ci-dessous et ayant au moins un type de groupe terminal moléculaire sélectionné dans le groupe de groupes représentés par les formules (2b) et (2c) décrites ci-dessous, et des composés sélectionnés dans le groupe de composés représentés par les formules (3) à (6) décrites ci-dessous, ou une substance imidifiée de ceux-ci, et
un solvant à base d'amide (B) représenté par la formule (1) décrite ci-dessous : 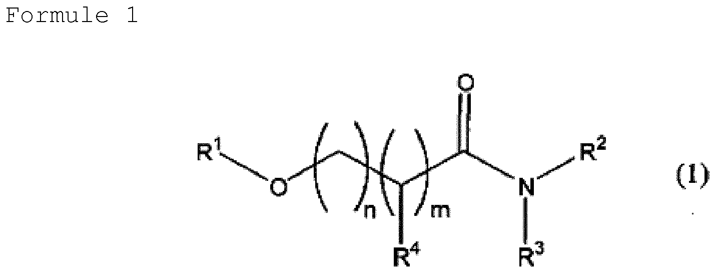 où, dans la formule (1), R¹ est un groupe organique ayant 1 à 18 atomes de carbone, R² et R³ satisfont à l'exigence (i) ou (ii) décrite ci-dessous, R⁴ est hydrogène ou méthyle, n est un entier de 0 à 3, et m est 0 ou 1 :
(i) ; R² et R³ sont chacun indépendamment hydrogène ou un groupe organique ayant 1 à 6 atomes de carbone ; ou
(ii) ; R² et R³ sont liés l'un à l'autre pour former une structure cyclique : 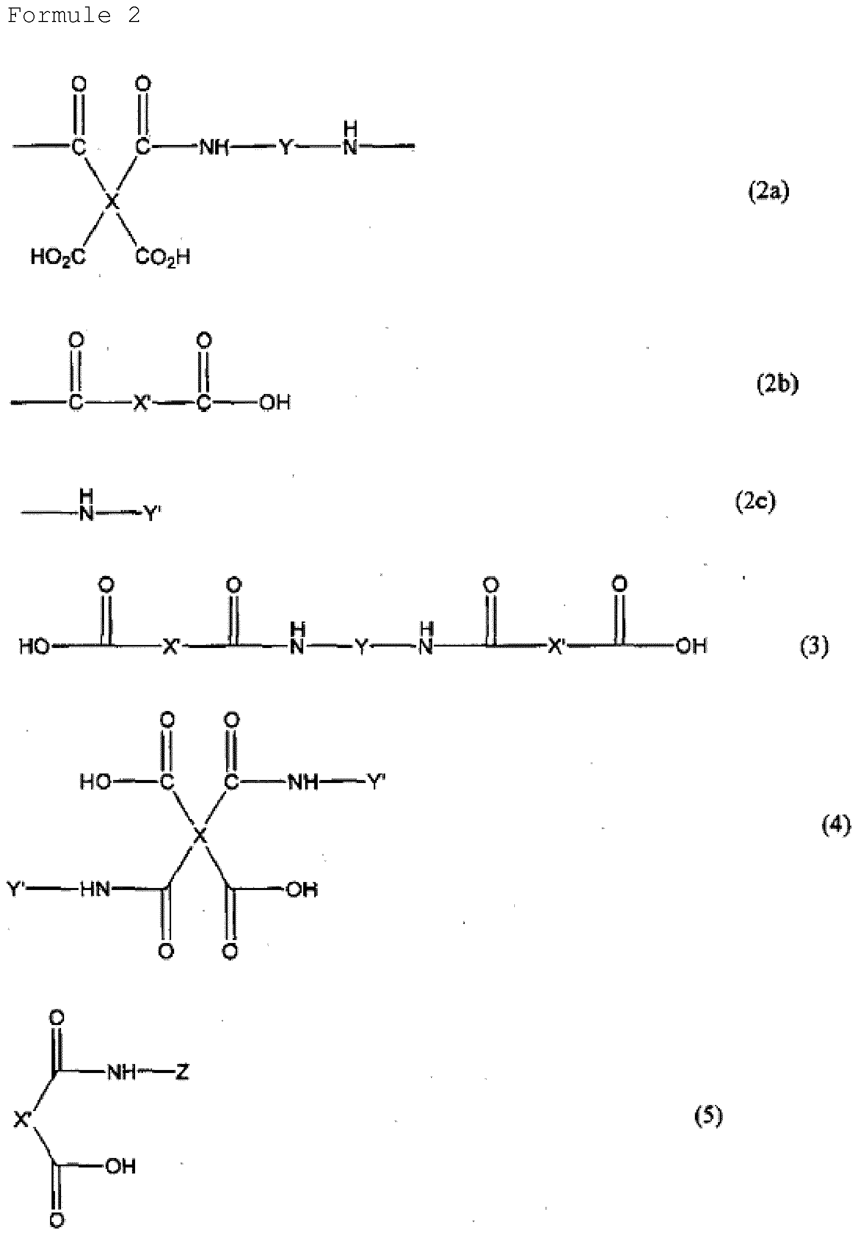 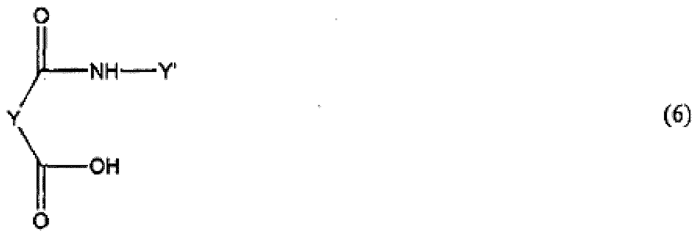
où, dans les formules (2a) et (4), X est chacun indépendamment carbone ou un groupe organique ayant 2 à 100 atomes de carbone, dans les formules (2a), (3) et (6), Y est chacun indépendamment un groupe organique ayant 1 à 100 atomes de carbone,
dans la formule (5), Z est un groupe organique ayant 1 à 100 atomes de carbone, dans les formules (2b), (3) et (5), X' est chacun indépendamment un groupe organique ayant 1 à 100 atomes de carbone, et
dans les formules (2c), (4) et (6), Y' est chacun indépendamment un groupe organique ayant 1 à 100 atomes de carbone.

2. Encre pour jet d'encre selon la revendication 1, dans laquelle R¹ dans la formule (1) est alkyle ayant 1 à 8 atomes de carbone.

3. Encre pour jet d'encre selon la revendication 1 ou 2, où le composé (2) est au moins un type de composé sélectionné dans le groupe de composés représentés par les formules (2-1) à (2-3) décrites ci-dessous : 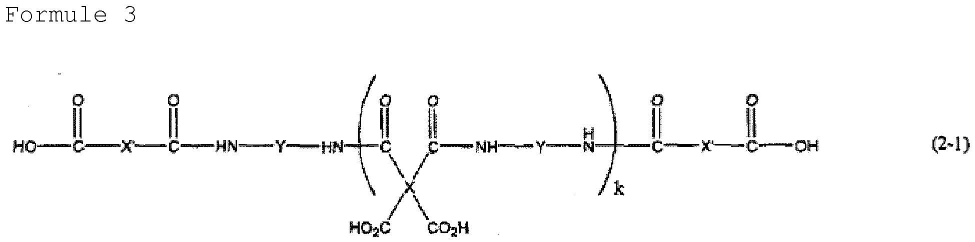 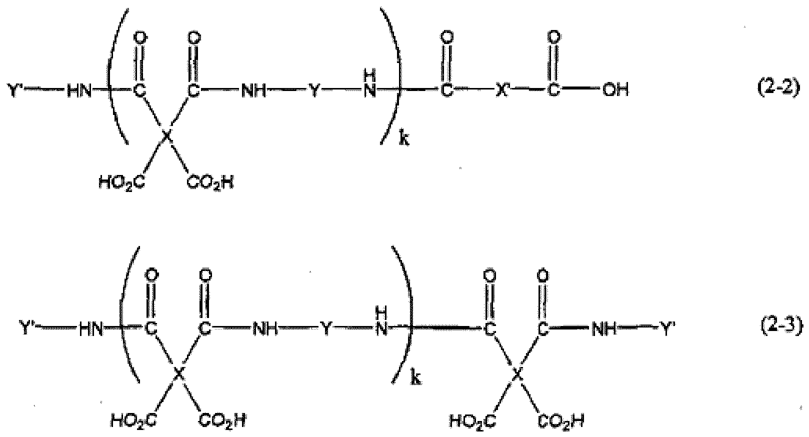 où, dans les formules (2-1) à (2-3), X est chacun indépendamment défini d'une manière identique à X dans les formules (2a) et (4),
dans les formules (2-1) à (2-3), Y est chacun indépendamment défini d'une manière identique à Y dans les formules (2a), (3) et (6),
dans les formules (2-1) et (2-2), X' est chacun indépendamment d'une manière identique à X' dans les formules (2b), (3) et (5), dans les formules (2-2) et (2-3), Y' est chacun indépendamment défini d'une manière identique à Y' dans les formules (2c), (4) et (6), et
dans les formules (2-1) à (2-3), k est chacun indépendamment un entier de 1 à 8.

4. Encre pour jet d'encre selon l'une quelconque des revendications 1 à 3, où X' dans les formules (2b), (3), (5), (2-1) et (2-2) est chacun indépendamment un groupe organique ayant un groupe d'hydrocarbone insaturé et ayant 2 à 100 atomes de carbone ou un groupe organique représenté par la formule (α) décrite ci-dessous, et
Y' dans les formules (2c), (4), (6), (2-2) et (2-3) est chacun indépendamment un groupe organique ayant un groupe d'hydrocarbone insaturé et ayant 2 à 100 atomes de carbone ou un groupe organique représenté par la formule (β) décrite ci-dessous : 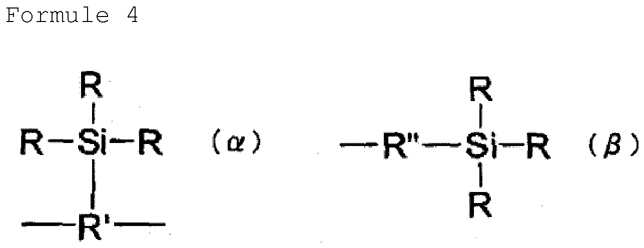 où, dans les formules (α) et (β), R est chacun indépendamment hydrogène, alkyle ayant 1 à 200 atomes de carbone ou alkoxy ayant 1 à 20 atomes de carbone, dans la formule (α), R' est un groupe organique ayant 1 à 20 atomes de carbone, et dans la formule (β), R" est un groupe organique ayant 1 à 20 atomes de carbone.

5. Encre pour jet d'encre selon l'une quelconque des revendications 1 à 4, contenant en outre le solvent (B') autre que le solvant à base d'amide (B).

6. Encre pour jet d'encre selon l'une quelconque des revendications 1 à 5, où le composant (A) est présent en une quantité de 5 à 95% en poids basé sur 100% en poids de l'encre pour jet d'encre.

7. Encre pour jet d'encre selon la revendication 5 ou 6, où le solvant à base d'amide (B) est présent en une quantité dans la plage de 1 à 100% en poids basé sur 100% du total du solvant à base d'amide (B) et du solvant (B').

8. Film polyimide formé en utilisant l'encre pour jet d'encre selon l'une quelconque des revendications 1 à 7.

9. Procédé pour former un film de polyimide, comprenant une étape pour former un film de revêtement en appliquant l'encre pour jet d'encre selon l'une quelconque des revendications 1 à 7 à un support selon une procédé de jet d'encre, et une étape pour former le film de polyimide en duricissant le film de revêtement.

10. Film de polyimide formé selon le procédé pour former le film de polyimide selon la revendication 9.

11. Film de polyimide selon la revendication 8 ou 10, dans lequel le film de polyimide présente un motif.

12. Substrat pour un matériau électronique, ayant le film de polyimide selon la revendication 8, 10 ou 11.

13. Composant électronique, ayant le substrat pour un matériau électronique selon la revendication 12.
